# EUROPÄISCHE PATENTSCHRIFT

(11) **EP 0 456 075 B1**
(45) Veröffentlichungstag und Bekanntmachung des Hinweises auf die Patenterteilung: **11.09.1996**
(21) Anmeldenummer: 91106920.1
(22) Anmeldetag: 29.04.1991
(51) Int. Cl.: G03F 7/004

(54) **Positiv arbeitendes strahlungsempfindliches Gemisch und strahlungsempfindliches Aufzeichnungsmaterial für die Belichtung mit DUV-Strahlung**
Positive-working radiation-sensitive mixture and radiation-sensitive recording material for exposure using deep UV-radiation
Composition sensible aux rayonnements à effet positif et matériel d'enregistrement sensible aux rayonnements UV profonds

(30) Priorität: 08.05.1990 DE 4014648
(43) Veröffentlichungstag der Anmeldung: 13.11.1991
(73) Patentinhaber: HOECHST AKTIENGESELLSCHAFT, 65926 Frankfurt am Main (DE)
(72) Erfinder: Röschert, Horst, Dr. Dipl.-Chem., W-6531 Ober-Hilbersheim (DE); Pawlowski, Georg, Dr. Dipl.-Chem., W-6200 Wiesbaden (DE); Merrem, Hans-Joachim, Dr. Dipl.-Chem., Basking Ridge, N.J. 07920 (US); Dammel, Ralph, Dr. Dipl.-Chem., W-6501 Klein-Winternheim (DE); Spiess, Walter, Dr. Dipl.-Phys., W-6110 Dieburg (DE)

(56) Entgegenhaltungen:
- EP-A- 0 378 067
- PATENT ABSTRACTS OF JAPAN vol. 13, no. 478 (P-951)(3826) 30 Oktober 1989, & JP- A- 01 188852

## Beschreibung

Die Erfindung betrifft ein positiv arbeitendes strahlungsempfindliches Gemisch enthaltend eine photoaktive Komponente und ein in Wasser unlösliches in wäßrig-alkalischer Lösung lösliches, zumindest aber quellbares Bindemittel.

Photoaktive Diazoderivate enthaltende strahlungsempfindliche Gemische, die für eine Bestrahlung mit energiereicher UV-Strahlung geeignet sind, werden seit einiger Zeit in der Literatur beschrieben.

In der US-A 4 339 522 werden positiv arbeitende strahlungsempfindliche Gemische genannt, die als photoaktive Verbindung ein Diazoderivat der Meldrumsäure enthalten. Diese Verbindung soll für eine Belichtung mit energiereicher UV-Strahlung im Bereich zwischen 200 bis 300 nm geeignet sein. Es zeigte sich aber, daß bei Anwendung dieser Mischungen die photoaktive Verbindung unter den in der Praxis häufig eingesetzten höheren Verarbeitungstemperaturen ausgeschwitzt wird; das strahlungsempfindliche Gemisch verliert seine ursprüngliche Aktivität, so daß reproduzierbare Strukturierungen nicht möglich sind.

In den EP-A 0 198 674 und 0 262 864, der JP-A 01-106 034, der US-A 4 622 283 und der SU-A 1 004 359 werden 2-Diazo-cyclohexan-1,3-dion- bzw. -cyclopentan-1,3-dion-Derivate als photoaktive Verbindungen für strahlungsempfindliche Gemische der beschriebenen Art bereitgestellt. Diese Verbindungen weisen eine geringere Flüchtigkeit auf, zeigen aber dafür, je nach vorliegendem Substitutionsmuster, eine schlechte Kompatibilität im strahlungsempfindlichen Gemisch. Dieses äußert sich insbesondere bei Trocknung der Schichten durch ein Auskristallisieren der photoaktiven Verbindung, durch deren Unlöslichkeit in praxisgerechten Lösemitteln oder durch eine durch Phasenseparation hervorgerufene Schichtinhomogenität.

Weitere, im tiefen UV-Bereich empfindliche und positiv arbeitende photoaktive Verbindungen sind aus der EP-A 0 129 694 und der US-A 4 735 885 bekannt. Die in diesen Dokumenten beschriebenen Verbindungen zeigen den Nachteil, daß die aus diesen bei Belichtung gebildeten Carbene keine für die gewünschte Carbonsäurebildung ausreichende Stabilität in der Matrix aufweisen. Dies führt zu einem unzureichenden Löslichkeitsunterschied zwischen den belichteten und unbelichteten Bereichen im Entwickler und damit zu einer unerwünscht hohen Abtragsrate der unbelichteten Bereiche. Eine mögliche Erklärung für dieses Phänomen geben C.G. Willson et al. in SPIE Vol. 771, "Advances in Resist Technology and Processing IV", 2 (1987).

In der EP-A 0 195 986 werden daher α-phosphorylsubstituierte Diazocarbonylverbindungen als photoaktive Verbindungen vorgeschlagen, da diese eine erhöhte Carbenstabilität aufweisen. In der Praxis dürften solche Verbindungen jedoch nur geringeren Einsatz finden, da potentiell als Dotiermittel verwendbare Atome, wie beispielsweise der in diesen Verbindungen enthaltene Phosphor, bei den Verarbeitungsprozessen peinlichst ausgeschlossen werden müssen.

H. Sugiyama, K. Ebata, A. Mizushima und K. Nate stellen in ihrem Aufsatz "Positive Excimer Laser Resist Prepared with Aliphatic Diazoketones" [SPIE Proc., 920, 51 (1988)] neue α-Diazoacetoacetate vor, die als photoaktive Verbindungen in positiv arbeitenden strahlungsempfindlichen Gemischen, insbesondere bei Verwendung von Strahlung im tiefen UV-Bereich, eingesetzt werden. Da es sich um Derivate der Acetoessigsäure handelt, ist die zur Estergruppe β-ständige Ketogruppe direkt einer endständigen Methylgruppe benachbart.

Diazoderivate der Acetoessigsäure werden auch in der EP-A 0 319 325 und der DE-A 38 41 571 als strahlungsempfindliche Komponenten im tiefen UV-Bereich (< 300 nm) eingesetzt. Strahlungsempfindliche Gemische, die die genannten Verbindungen als photoaktive Komponenten aufweisen, zeigen gute Ausbleicheigenschaften, ihre Eigenschaften hinsichtlich der Bilddifferenzierung sind aber schlecht.

Aliphatische Bis(carbonyl)diazomethane, die in der JP-A 01-080 944 Verwendung finden, sind durch eine unzureichende thermische Stabilität gekennzeichnet, weshalb solche Verbindungen in der Praxis kaum Verwendung finden dürften. Für Bis(carbonyl)diazomethane, die in den JP-A 63-253 938, 01-106 036 und 01-010 237 beansprucht werden, gilt das gleiche wie für die Derivate der Acetoessigsäure.

Aufgabe der Erfindung war es daher, ein positiv arbeitendes strahlungsempfindliches Gemisch, enthaltend eine photoaktive Verbindung mit hoher Empfindlichkeit im tiefen UV-Bereich, bereitzustellen, das die zahlreichen beschriebenen Nachteile nicht aufweist, und eine gute Differenzierung zwischen den belichteten und unbelichteten Schichtbereichen zuläβt. Darüber hinaus sollen die Verbindungen mit den unterschiedlichsten, in der Praxis verwendbaren Polymeren gut verträglich sein, aus dem strahlungsempfindlichen Gemisch nicht ausschwitzen und eine hohe thermische Stabilität sowie praxisgerechte Lichtempfindlichkeiten aufweisen.

Die Lösung der Aufgabe erfolgt durch Bereitstellen eines positiv arbeitenden strahlungsempfindlichen Gemisches, enthaltend im wesentlichen eine photoaktive Komponente und ein in Wasser unlösliches, aber in wäßrig-alkalischer Lösung lösliches, zumindest aber quellbares Bindemittel, dadurch gekennzeichnet, daß als photoaktive Komponente eine α-Diazo-β-ketoesterund Sulfonsäureester-Einheiten enthaltende Verbindung der allgemeinen Formel I verwendet wird, 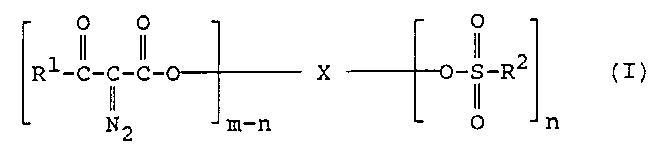 worin
- R¹: einen aliphatischen, cycloaliphatischen, araliphatischen oder aromatischen Rest mit 4 bis 20 Kohlenstoffatomen, wobei einzelne CH₂-Gruppen durch Sauerstoff- oder Schwefelatome oder durch -NR³- oder NH-Gruppen ersetzt sein können und/oder Ketogruppen enthalten,
- R²: einen aliphatischen Rest mit 1 bis 8 Kohlenstoffatomen, in denen CH₂-Gruppen durch Sauerstoffatome oder NH-Gruppen ersetzt und/oder Ketogruppen enthalten sein können, oder einen der für R¹ angegebenen Reste,
- X: einen aliphatischen, cycloaliphatischen, carbocyclischen, heterocyclischen oder araliphatischen Rest mit 2 bis 22 Kohlenstoffatomen, wobei einzelne CH₂-Gruppen durch Sauerstoff oder Schwefelatome oder durch die Gruppen -NR³-, -C(O)-O-, -C(O)-NR³-, 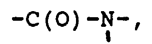 -NR³-C(O)-NR⁴-, -O-C(O) -NR³-, 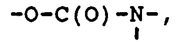 -O-C(O)-O- oder CH-Gruppen durch 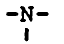 ersetzt sein können, worin
- R³ und R⁴: voneinander unabhängig für Wasserstoff oder einen aliphatischen, carbocyclischen oder araliphatischen Rest stehen,
- m: eine ganze Zahl von 3 bis 8 und
- n: eine ganze Zahl von 1 bis 3
bedeuten.

R³ und R⁴ bedeuten in der bevorzugten Ausführungsform Wasserstoff, (C₁-C₃)Alkyl, (C₆-C₁₂)Aryl oder (C₆-C₁₁)Aralkyl, wobei die Reste - insbesondere Aryl oder Aralkyl - am Kern durch (C₁-C₃)Alkyl, (C₁-C₃)Alkoxy, Halogen, insbesondere Chlor oder Brom, oder Amino, insbesondere ein primäres oder sekundäres Amin, ebenso substituiert sein können. Besonders bevorzugt bedeuten R³ und R⁴ Wasserstoff oder (C₁-C₃)Alkyl, insbesondere aber Wasserstoff.

Die für R¹, R² und X stehenden Reste können ggf. substituiert sein, insbesondere durch (C₁-C₃)Alkyl, (C₁-C₃)Alkoxy, Halogen, insbesondere Chlor oder Brom, Nitril, Amino oder Nitro. Bevorzugt sind Reste R¹, R² und X, die substituiert sind durch (C₁-C₃)Alkyl oder (C₁-C₃)Alkoxy. Insbesondere wenn R¹ und X für einen Alkyl- bzw. Alkylenrest stehen, werden die unsubstituierten Derivate bevorzugt. Wenn R² ein Alkylrest bedeutet, werden dagegen die substituierten Derivate bevorzugt.

Die aliphatischen Reste R¹ können sowohl geradkettig als auch verzweigt sein. Die Zahl der Kettenglieder beträgt hierbei bevorzugt 4 bis 10, insbesondere 4 bis 8. Hierunter fallen die besonders bevorzugten reinen Kohlenstoffketten wie auch die substituierten, in denen CH₂-Gruppen durch Sauerstoffatome oder -NH-Gruppen ersetzt und/oder Ketogruppen enthalten sind, worunter auch Ether-, Keto-, Ester-, Amidooder Imidogruppen zu sehen sind, d.h. auch Ester der Carbaminsäure. In den reinen aliphatischen Resten R¹ treten Ethergruppen besonders bevorzugt zweimal pro Rest R¹ auf. Sofern es sich um reine, insbesondere geradkettige, Kohlenstoffketten handelt, ist eine Begrenzung der Kohlenstoffzahl nicht zwingend; es können durchaus aliphatische Reste mit bis zu 20 Kohlenstoffatomen zum Einsatz kommen. Besonders bevorzugt ist dennoch der tert.-Butylrest.

Sofern R¹ ein cycloaliphatischer Rest bedeutet, ist die Zahl der Ringglieder bevorzugt 4, 5, 6 oder 12, insbesondere 4, 5 oder 6. Die unsubstituierten Varianten werden besonders bevorzugt. Als Beispiele gelten der Cyclobutyl-, Cyclopentyl- und der Cyclohexylrest. Besonders bevorzugt ist der Cyclohexylrest.

Ist R¹ ein araliphatischer Rest, so ist die Zahl der Glieder des aliphatischen Teils des Restes 2 bis 11, insbesondere 2 bis 5. Sofern es sich um eine reine Kohlenstoffkette im aliphatischen Teil handelt, ist die Anzahl der C-Atome bevorzugt 1 oder 2. Werden CH₂-Gruppen durch Sauerstoffatome ersetzt, so können diese als Brückenglieder zwischen aromatischem und aliphatischem Teil des Rests R¹ vorkommen, aber auch im aliphatischen Teil selbst. In beiden Fällen ist es besonders bevorzugt, wenn die verbleibende Gesamtzahl der Kohlenstoffatome als Kettenglieder im aliphatischen Teil dieses Restes 1 oder 2 beträgt, wobei das Ether-Sauerstoffatom im Falle von 2 Kohlenstoffatomen als Kettenglieder in der Weise angeordnet ist, daß es den beiden CH₂-Gruppen direkt benachbart ist. Hierunter sind zu nennen der Benzyl-, der Phenoxymethyl- und der Benzyloxymethylrest. Werden zusätzlich noch weitere CH₂-Gruppen im aliphatischen Teil des araliphatischen Restes R¹ durch Heteroatome ersetzt und/oder Substitutionen an diesem vorgenommen, so ist die Gesamtzahl der Kettenglieder des aliphatischen Teils 3 bis 5. Hierunter fallen u.a. über Estergruppen gebundene Phenyl- oder Benzylreste, aber auch die Benzyl- oder Phenylester der Carbaminsäure. Der aliphatische Teil kann aber auch die Imidogruppe einer aromatischen Dicarbonsäure darstellen. Der aromatische Teil eines solchen Restes besteht insbesondere aus 6 C-Atomen. Wenn der aromatische Teil des araliphatischen Restes direkt benachbart zur Ketogruppe steht, d.h. als Arylenrest eingebunden ist, so gelten für den darin vorkommenden aliphatischen Teil keine Beschränkungen hinsichtlich der Zahl mindestens vorkommender C-Atome.

Die aromatischen Reste R¹ weisen bevorzugt keine Heteroatome wie z.B. Sauerstoff im Ringsystem auf. Ist R¹ ein aromatischer Rest, so enthält er bevorzugt 6 bis 12 C-Atome, insbesondere 6 C-Atome, d.h. er entspricht einem Phenylrest. Aromatische Reste R¹ sind generell aber nicht bevorzugt.

Insgesamt sind als besonders bevorzugte Reste R¹ tert.-Butyl, n-Hexyl, Nonyl, Octadecyl, 2,5-Dioxahexyl, Cyclopentyl, Cyclohexyl, Benzyl, Phenoxymethyl und Benzyloxymethyl zu nennen. Insbesondere bevorzugt ist der tert.-Butyl-, Phenoxymethyl- und der Cyclohexylrest.

Die aliphatischen Reste R² können sowohl geradkettig als auch verzweigt sein. Die Zahl der Kettenglieder beträgt hierbei bevorzugt 1 bis 8, insbesondere 2 bis 6. Hierunter fallen sowohl reine Kohlenstoffketten als auch die substituierten, in denen CH₂-Gruppen durch Sauerstoffatome oder -NH-Gruppen ersetzt und/oder Ketogruppen enthalten sind, worunter Ether-, Keto-, Ester-, Amido oder Imidogruppen fallen. In den reinen aliphatischen Resten R² treten verzweigte Kohlenstoffketten bevorzugt auf. Eine Begrenzung der Kohlenstoffzahl ist nicht zwingend; es können durchaus aliphatische Reste mit mehr als 8 Kohlenstoffatomen auftreten. Bevorzugt sind dennoch der Isopropylund der tert.-Butylrest.

Sofern R² ein cycloaliphatischer Rest bedeutet, ist die Zahl der Ringglieder bevorzugt 4, 5, 6 oder 12, insbesondere 5 oder 6. Die unsubstituierten Varianten werden bevorzugt. Cycloaliphatische Reste R² sind aber insgesamt nicht bevorzugt.

Ist R² ein araliphatischer Rest, so ist die Zahl der Glieder des aliphatischen Teils 2 bis 11, insbesondere 2 bis 5. Sofern es sich um eine reine Kohlenstoffkette handelt, ist die Anzahl der C-Atome bevorzugt 1. Werden CH₂-Gruppen durch Sauerstoffatome ersetzt, so können diese als Brückenglied zwischen aromatischem und aliphatischem Teil des Rests R² vorkommen, aber auch im aliphatischen Teil. In beiden Fällen ist es besonders bevorzugt, wenn die verbleibende Gesamtzahl der Kohlenstoffatome als Kettenglieder im aliphatischen Teil dieses Restes 1 oder 2 beträgt. Der aromatische Teil des araliphatischen Restes R² besteht insbesondere aus 6 C-Atomen.

Die aromatischen Reste R² können Heteroatome, wie Schwefel oder Sauerstoff, in ihrem Ringsystem aufweisen. Diese sind bevorzugt substituiert. Ist R² ein aromatischer Rest, so enthält er bevorzugt 6 bis 12 C-Atome, insbesondere 6 C-Atome, d.h. er entspricht einem Phenylrest. Aromatische Reste R² sind besonders bevorzugt. Sind die aromatischen Reste R² substituiert, so handelt es sich bevorzugt um Alkyl-, Alkoxy-, Halogen-, Nitril und Nitrogruppen. Aber auch Amino- und Amidogruppen kommen als Substituenten in Frage. Hinsichtlich der Anzahl der Substituenten und des Substitutionsmusters gelten keine Beschränkungen.

Insgesamt sind als besonders bevorzugte Reste R² niedere Alkylreste (C1-C4), wie Isopropyl, tert.-Butyl, die ggf. mit Halogenatomen substituiert sind, und aromatische Verbindungen zu nennen. Insbesondere bevorzugt sind in 4-Stellung mit Methyl-, tert.-Butyl-, Trifluormethyl-, Brom- oder Cyanogruppen substituierte Phenylreste.

X steht für einen aliphatischen oder cycloaliphatischen Rest, der gesättigt wie auch ungesättigt sein kann, einen carbocyclischen, heterocyclischen oder araliphatischen Rest mit 2 bis 22 Kohlenstoffatomen, insbesondere mit 2 bis 17 Kohlenstoffatomen. In diesen Resten kann zudem mindestens eine CH₂-Gruppe durch Heteroatome wie Sauerstoff, Schwefel oder durch Gruppen wie -NR³-, -C(O)-O-, -C(O)-NR³-, 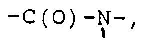 -NR³-C(O)-NR⁴-, -O-C(O)-NR³-, 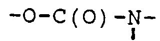 oder -O-C(O)-O- oder CH-Gruppen durch 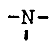 ersetzt sein. Insbesondere bevorzugt sind bei den aliphatischen oder araliphatischen Resten diejenigen Varianten, in denen maximal zwei CH₂-Gruppen durch einen Typ der oben genannten Gruppen ersetzt worden sind. Werden CH₂-Gruppen durch Heteroatome ersetzt, so kann die Anzahl dieser bevorzugt maximal 5, insbesondere maximal 3 sein. Dabei ist besonders bevorzugt, wenn alle zu ersetzenden CH₂-Gruppen durch Heteroatome eines Typs ersetzt werden.

Handelt es sich um einen unsubstituierten, gesättigten oder ungesättigten aliphatischen Rest X, so enthält dieser in der bevorzugten Variante maximal 6 Kohlenstoffatome. Zu den ungesättigten aliphatischen Resten X zählen insbesondere solche, deren CH₂- bzw. CH-Gruppen nicht durch Heteroatome bzw. den obengenannten Gruppen ersetzt sind. Sie enthalten in ihrer besonderen Ausführungsform maximal eine C-C-Mehrfachbindung; die Zahl der Kettenglieder ist in einem solchen Rest besonders bevorzugt 4. Die genannten Reste X sind bevorzugt 3-bindig.

Werden in den aliphatischen Resten X CH₂-Gruppen durch Heteroatome ersetzt, so werden diese bevorzugt von Alkylenresten mit jeweils mindestens 2 CH₂-Gruppen eingebunden. Ist Schwefel das Heteroatom im aliphatischen Rest X, so kommt dieser besonders bevorzugt pro Rest lediglich einmal vor. Er ist insbesondere von Alkylresten mit jeweils maximal 3 CH₂-Gruppen umgeben. Wird Sauerstoff als Heteroatom im aliphatischen Rest eingesetzt, so kann dieser häufiger pro Rest vorkommen, insbesondere 2 bis 4 mal. In diesem Fall enthalten die Alkylenreste, in die zwei Sauerstoffatome eingebunden sind, mindestens 3 CH₂-Gruppen.

Ist die Anzahl der Kohlenstoffatome im unsubstituierten aliphatischen Rest größer als 3, so liegt dieser Alkylenrest insbesondere als verzweigtes Isomeres vor. Insbesondere bevorzugt ist der tert.-Butyl- oder der tert.-Pentylrest.

Im Rest X können auch mehrere Alkylreste, insbesondere der tert.-Butyl- oder tert.-Pentylrest, über Heteroatome oder CH₂-Gruppen ersetzende Gruppen, die oben genannt sind, verbunden sein. Dies ist dann besonders bevorzugt, wenn diese Reste mehr als zweibindig sind:

Sofern die tert.-Butyl oder tert.-Pentylreste dreibindig sind, ist m mindestens 3. m = 4 wird bevorzugt erreicht, indem ein zweibindiger tert.-Pentyl- oder tert. -Butylrest im Rest X zweimal vorliegt. m = 4 wird auch erreicht, indem ein zweibindiger Propylrest am Rest X zweimal vorkommt.

m = 6 wird bevorzugt erreicht, indem zwei dreibindige Reste (tert.-Butyl oder tert.-Pentyl) oder drei zweibindige Propylreste im Rest X vorliegen. m = 8 wird z.B. erreicht durch die Kombination von 4 zweibindigen Resten oder von 2 dreibindingen Resten mit einem zweibindigen Rest.

Die mehr als Zweibindigkeit des Restes X kann auch dadurch erreicht werden, daß mehr als zweibindige Heteroatome enthalten sind: Wird im aliphatischen Rest X eine CH-Gruppe durch 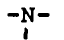 ersetzt, so können m-Werte von 3 erreicht werden. Werden zwei CH-Gruppen durch 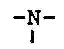 ersetzt, so kann m maximal 4 erreichen.

In allen Fällen, in denen im Rest X CH-Gruppen durch 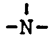 ersetzt werden, findet bevorzugt keine Substitution einer CH₂-Gruppe durch ein weiteres Heteroatom oder durch eine der oben beschriebenen Gruppen statt. Die Anzahl der CH₂-Gruppen, die zwischen dem Stickstoffheteroatom und dem an den Rest X gebundenen Rest nach der allgemeinen Formel I liegen, beträgt mindestens 2; insbesondere ist diese die Zahl 2.

Reine cycloaliphatische Reste, d.h. unsubstituierte, als Varianten des Restes X sind nicht bevorzugt. Als cycloaliphatischer Rest wird insbesondere der Cyclohexylrest genannt. Dieser kann aber substituiert sein, insbesondere durch Hydroxyl und/oder Alkyl oder Alkylen, wobei dessen Bindigkeit bevorzugt durch die Anzahl der Alkylensubstituenten am cycloaliphatischen Rest bestimmt wird. Ganz besonders bevorzugt ist ein Cyclohexylrest, der vier Methylengruppen als Substituenten trägt, die die Bindung der α-Diazo-β-ketoester- und der Sulfonsäureester-Einheiten nach der allgemeinen Formel I gewährleisten (m = 5).

Zumeist handelt es sich bei den cycloaliphatischen Resten als Varianten des Restes X mehr um eine Kombination aus einem cycloaliphatischen und einem kettenförmigen aliphatischen Teil. In diesem Fall ist der cycloaliphatische Teil bevorzugt nicht in der Weise substituiert, daß CH₂-Gruppen aus diesem Teil durch Heteroatome oder durch Gruppen aus der obengenannten Reihe ersetzt sind.

Als Ausnahme gilt ein sechsgliedriger Ring (Heterocyclus) aus drei Carbonsäureamideinheiten, in dem die Koppelung der α-Diazo-β-ketoester- und der Sulfonsäureester-Einheiten der allgemeinen Formel I über Ethylengruppen an den Amidostickstoff erfolgt. m ist daher 3 und n ist 1.

Wenn X aber eine Kombination aus einem reinen cycloaliphatischen Teil und einem oder mehreren kettenförmigen aliphatischen Teilen mit 2 oder mehreren Kohlenstoffatomen ist, so ist der cycloaliphatische Teil insbesondere einer CH₂-Gruppe, die durch eine der obengenannten Heteroatome oder Gruppen ersetzt ist, direkt benachbart. Besonders bevorzugt ist diejenige Variante, in der der cycloaliphatische Teil einem Stickstoffatom, insbesondere den Gruppen 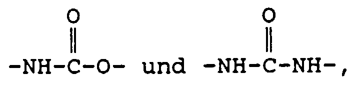 direkt benachbart ist. In diesem Fall wird als cycloaliphatischer Teil bevorzugt ein Cyclohexylrest eingesetzt, der sowohl einbindig als auch zweibindig sein kann, letzteres bevorzugt in 1,4-Position. In beiden Fällen erfolgt die Verknüpfung einer der freien Valenzen der Reste 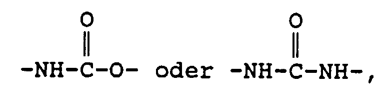 mit α-Diazo-β-ketoester- und Sulfonsäureester-Einheiten nach der allgemeinen Formel I über ein Alkylenrest mit mindestens 2 CH₂-Einheiten. Sofern es sich um einen 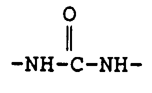 Rest handelt, ist als verknüpfende Gruppe bevorzugt ein tert.-Butylenrest formuliert. Sofern es sich um einen

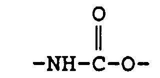

Rest handelt, d.h. die diskutierte Verknüpfung über das Sauerstoffatom dieser Gruppe erfolgt, wird bevorzugt ein Ethylenrest als verknüpfende Gruppe eingesetzt.

Handelt es sich um einen araliphatischen Rest als Variante der Gruppe X, so kann der aromatische Teil, insbesondere ein Phenyl-, bzw. wenn Zweibindigkeit vorliegt, ein Phenylenrest, sowohl über ein Sticktoffatom als auch über ein Sauerstoffatom gebunden sein. Bevorzugt ist allerdings auch hier - wenn beide Atome zur Auswahl stehen - das Stickstoffatom. Als Beispiel, in dem der aromatische Teil direkt über ein Sauerstoffatom gebunden ist, zählt ein über eine Ethylengruppe an die α-Diazo-β-ketoester- und/ oder Sulfonsäureester-Einheit gebundenes Ethersauerstoffatom. Als dritte Variante ergibt sich in diesem Fall noch die Möglichkeit, daß der aromatische Rest, insbesondere wenn er einbindig ist, über die Ketogruppe eines Restes 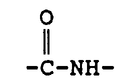 gebunden vorliegt. Das Stickstoffatom trägt in diesem Fall insbesondere einen Ethylenrest.

Im Falle des Vorliegens eines araliphatischen Restes X ist der über das Stickstoffatom eines eine CH₂-Gruppe ersetzenden Restes 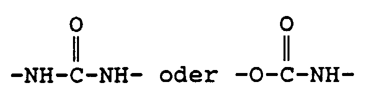 gebundene aliphatische Teil des Restes X insbesondere ein tert.-Butylen- oder ein Ethylenrest; ist der aliphatische Teil über das Sauerstoffatom gebunden, so ist dieser besonders bevorzugt ein Ethylenrest.

Daß über das Sauerstoffatom der obengenannten, eine CH₂-Gruppe im Rest X zu ersetzenden Gruppen bevorzugt eine Ethylengruppe gebunden ist, läßt sich auch auf aliphatische Reste im allgemeinen übertragen, während über das Stickstoffatom sowohl Ethylenreste wie auch höhere aliphatische Reste, insbesondere aus Kohlenstoffketten mit mehr als 3 Kohlenstoffatomen, gebunden sind. Bevorzugt ist der tert.-Butylenrest.

Sofern es sich um araliphatische und aliphatische Reste X handelt, werden bevorzugt maximal 2 CH₂-Gruppen durch Reste wie 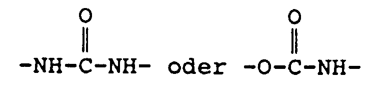 ersetzt. Der Rest 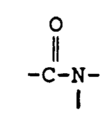 als Ersatz für eine CH-Gruppe liegt in der besonders bevorzugten Ausführungsform nur einmal in einem Rest X vor.

In den oben dargestellten Varianten der Reste R¹, R² und X ist m bevorzugt eine ganze Zahl von 3 bis 8 und n eine ganze Zahl von 1 bis 3. Besonders bevorzugt ist m eine ganze Zahl von 3 bis 6 und n = 1 oder 2.

Die vorstehend näher charakterisierten, erfindungsgemäßen mehrfunktionellen Verbindungen der allgemeinen Formel I sind als photoaktive Komponenten in einem strahlungsempfindlichen Gemisch hervorragend geeignet. Insbesondere sind die erfindungsgemäßen Verbindungen geeignet für die Belichtung mit Strahlung einer Wellenlänge von 190 bis 350 nm. Die Verwendung der neuen mehrfunktionellen Verbindungen als photoaktive Komponenten in strahlungsempfindlichen Gemischen zur Herstellung von hochauflösenden Photoresists für die Mikrolithographie wird in der gleichzeitig eingereichten deutschen Patentanmeldung P 40 14 649.9 beschrieben.

Ebenso ist Gegenstand der Erfindung ein Verfahren zur Herstellung der erfindungsgemäßen, mehrfunktionellen Verbindungen mit α-Diazo-β-ketoester- und Sulfonsäureester-Einheiten. Es hat sich als besonders günstig erwiesen, zunächst geeignete Vorstufen für β-Ketoester-Sulfonsäureester der allgemeinen Formel II zu synthetisieren und diese in einer Folgereaktion durch einen sogenannten Diazotransfer in die α-Diazo-β-ketoester-Sulfonsäureester der Formel I zu überführen (vgl. M. Regitz et al., Org. Prep. Proced., 1, 99 (1969)): 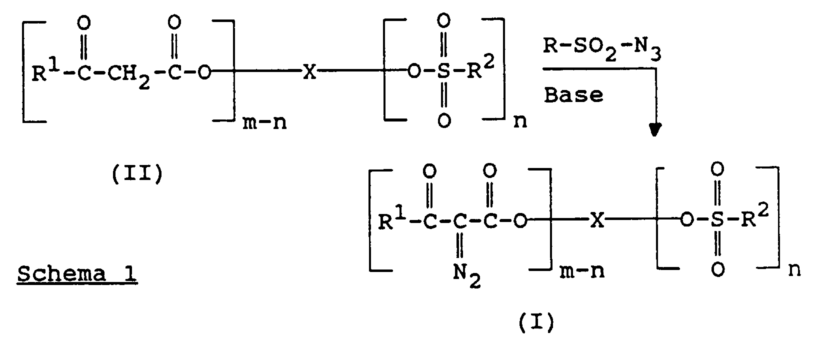 Zu diesem Zweck wird ein β-Ketoester-Sulfonsäureester der allgemeinen Formel II (in der R¹, R² und X die in Formel I angegebene Bedeutung aufweisen) in der 5 bis 50fachen, bevorzugt 10fachen Menge eines geeigneten Lösemittels (bezogen auf das Gemisch) gelöst und die Lösung auf eine Temperatur zwischen -15 °C bis +15 °C, bevorzugt -5 °C bis +5 °C gekühlt. Als Lösemittel geeignet sind Alkohole, wie Methanol, Ethanol, Alkoholether wie Ethylenglykolmonomethylether, chlorierte Kohlenwasserstoffe, wie Dichlormethan oder Trichlormethan, oder bevorzugt aliphatische Nitrile, wie Acetonitril, oder Gemische dieser Lösemittel. Besonders bevorzugt werden dabei solche, die einen Siedepunkt zwischen 30 °C und 140 °C aufweisen. Die eigentliche erfindungsgemäße Umsetzung kann nach 3 Varianten durchgeführt werden.

### Variante A:

Die gekühlte Lösung wird mit dem 1- bis 1,3-fachen Überschuß - bezogen auf die Anzahl der umzusetzenden aktivierten Methylengruppen - eines Diazotransferreagenzes versetzt. Als Transferreagenzien haben sich insbesondere aromatische und aliphatische Sulfonylazide, wie Toluolsulfonylazid, 4-Carboxyphenylsulfonylazid, 2-Naphthalinsulfonylazid oder Methylsulfonylazid bewährt. Bezogen auf das Sulfonylazid wird dann die äquimolare Menge einer Base, bevorzugt eines tertiären Amins, zu der Lösung hinzugefügt. Die Temperatur der Mischung muß dabei konstant gehalten werden. Bevorzugte Amine sind beispielsweise Triethylamin, Triisopropylamin oder 1,4-Diaza-bicyclo[2.2.2]octan. Besonders bevorzugt ist die Verwendung von Triethylamin als Base. Die erhaltene Mischung wird 5 bis 50 Minuten, bevorzugt 10 bis 15 Minuten, bei der vorgegebenen Temperatur gerührt, auf Raumtemperatur erwärmt und dabei weitere 1 bis 24 Stunden, bevorzugt 2 bis 4 Stunden, gerührt. Je nach Art des eingesetzten Sulfonylazids kann das dabei gebildete Sulfonylamid ausfallen, so daß es nach Beendigung der Reaktion ggf. abfiltriert wird.

### Variante B:

Alternativ zu Variante A können auch der β-Ketoester-Sulfonsäureester der allgemeinen Formel II und das Amin unter den vorstehend beschriebenen Bedingungen vorgelegt werden. Anschließend kann das Sulfonylazid unter Beibehaltung der Temperatur zudosiert werden.

### Variante C:

Als besonders günstig hat sich jedoch eine modifizierte Variante A erwiesen, in der die Lösung des β-Ketoester-Sulfonsäureesters der allgemeinen Formel II zunächst nur mit dem 0,7- bis 0,9fachen Überschuß - bezogen auf die Anzahl der umzusetzenden aktivierten Methylengruppen - eines Sulfonylazids, bevorzugt Toluolsulfonylazid, versetzt wird und unter Beibehaltung der vorgegebenen Temperatur die Gesamtmenge des Amins zugesetzt wird. Die Mischung wird dann ggf. unter Erwärmung auf Raumtemperatur gerührt. Nach etwa 10 bis 120 Minuten ist das Toluolsulfonylazid chromatographisch nicht mehr nachweisbar. Hierauf wird die Mischung ggf. erneut gekühlt und diesmal mit dem 0,6-bis 0,1fachen Überschuß von 4-Carboxyphenylsulfonylazid versetzt, so daß ein Gesamtüberschuß an Sulfonylazid entsprechend der Variante A entsteht. Die Rohprodukte, die nach dieser Variante hergestellt werden, zeigen eine hohe Reinheit.

Das nach den Varianten A bis C erhaltene Gemisch wird vom Lösemittel und überschüssigen Reagenzien befreit und in einem inerten, nicht mit Wasser mischbaren Lösemittel, insbesondere Dichlormethan oder Diethylether, aufgenommen. Die Mischung wird zur Entfernung von Sulfonylamidresten zweimal mit 5- bis 25%iger Kalilauge und anschließend mit Wasser neutral gewaschen, über einem geeigneten Trocknungsmittel getrocknet und erneut vom Lösemittel befreit. Der verbleibende Rückstand, insbesondere bei Anwendung der Variante C fast ausschließlich aus reinem α-Diazo-β-ketoester-Sulfonsäureester der allgemeinen Formel I bestehend, kann nach bekannten Methoden, beispielsweise mittels Kristallisation oder Chromatographie, aufgearbeitet werden.

Die Herstellung der zur Umsetzung zu den erfindungsgemäßen mehrfunktionellen Verbindungen mit α-Diazo-β-ketoester- und Sulfonsäureester-Einheiten der allgemeinen Formel I erforderlichen β-Ketoester-Sulfonsäureester der allgemeinen Formel II kann auf unterschiedliche, aus der Literatur bekannte Verfahrensweisen erfolgen:
1. Entsprechend dem Schema 2 erfolgt eine Umsetzung eines monofunktionellen 5-Acyl-2,2-dialkyl-1,3-dioxan-4,6-dions (5-Acyl-meldrumsäure) der allgemeinen Formel III mit einem mehrwertigen Alkohol-Sulfonsäureester der allgemeinen Formel IV zum mehrfunktionellen β-Ketoester-Sulfonsäureester der allgemeinen Formel II. Die Herstellung von 5-Acyl-meldrumsäurederivaten der allgemeinen Formel III und deren Umsetzung zu β-Ketoestern ist für monofunktionelle Verbindungen bekannt und kann beispielsweise analog zu den Vorschriften von Y. Oikawa et al., J. Org. Chem., 43, 2087 (1987) durch Umsetzung von Säurechloriden mit Meldrumsäure oder analog zu Vorschriften von P. Houghton und D. J. Lapham, Synthesis, 1982, 451 ff., erfolgen. Auch für die Umsetzung zu mehrfunktionellen β-Ketoestern gemäß der obengenannten Literatur findet man Beispiele in den nicht vorveröffentlichten deutschen Patentanmeldungen P 39 00 735.9 und P 39 00 736.7. Die Produkte werden in ihrer Enolform isoliert. 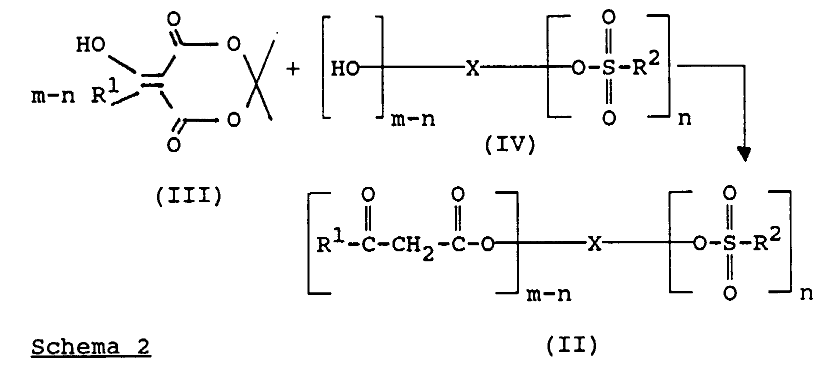
2. Entsprechend dem Schema 3 erfolgt die Umsetzung eines monofunktionellen β-Ketoesters, bevorzugt eines Methyl- oder Ethylesters der allgemeinen Formel V, mit einem mehrwertigen Alkohol-Sulfonsäureester der allgemeinen Formel IV zum mehrfunktionellen β-Ketoester der allgemeinen Formel II. Die Umesterungsreaktion zur Herstellung von monofunktionellen β-Ketoestern ist bekannt und wird von A.R. Bader et al. in J. Am. Chem. Soc., 73, 4195 ff., (1951) beschrieben.

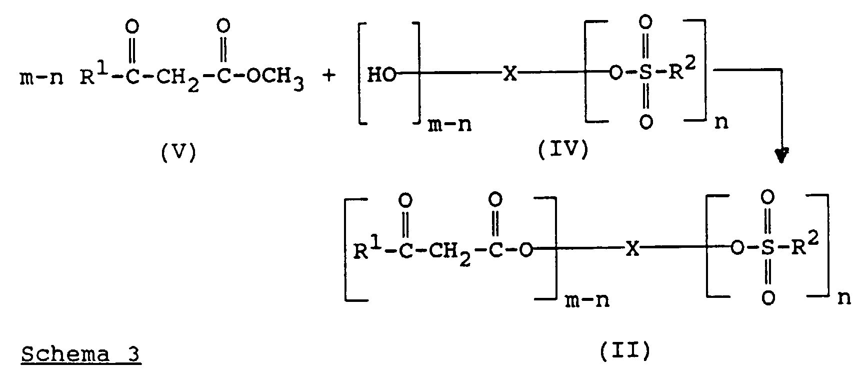

Bei der Reaktionsfolge nach Schema 2 wird das betreffende Derivat der 5-Acyl-meldrumsäure der allgemeinen Formel III mit der zum gewünschten Umsetzungsgrad erforderlichen Menge des betreffenden mehrfunktionellen Alkohol-Sulfonsäureesters der allgemeinen Formel IV versetzt und das Gemisch anschließend in der 5- bis 20fachen, bevorzugt 10fachen, Menge eines nicht mit Alkoholen oder der Meldrumsäure reagierenden Lösemittels, beispielsweise eines Ketons wie Aceton oder Ethylmethylketon, oder eines Ethers, wie 1,2-Dimethoxyethan oder Dioxan, ggf. unter Erwärmung, gelöst. Die klare Lösung wird auf eine Temperatur von 60 bis 120 °C, bevorzugt auf 80 bis 100 °C, erwärmt. Die beginnende Umsetzung macht sich durch lebhafte Kohlendioxidentwicklung bemerkbar. Die Mischung wird etwa 1 bis 6 Stunden, bevorzugt 2 bis 3 Stunden, bei der vorgegebenen Temperatur gerührt, bis keine CO₂-Entwicklung mehr beobachtbar ist.

Anschließend wird das Lösemittel im Vakuum abgetrennt. Obwohl der betreffende β-Ketoester-Sulfonsäureester der allgemeinen Formel II in hoher Reinheit anfällt, kann das Produkt ggf. weiterhin nach den dem Fachmann bekannten Methoden gereinigt werden.

Besonders geeignete Derivate der 5-Acyl-meldrumsäure der allgemeinen Formel III sind solche, in denen R¹ Cyclobutyl, Butyl, Pentyl, Cyclopentyl, Hexyl, Cyclohexyl, Heptyl, Octyl, Nonyl, Adamantyl oder höhere Alkylreste mit bis etwa 22 Kohlenstoffatomen bedeuten, die ggf. durch weitere Alkylreste, Alkoxyalkylreste, Arylreste, Alkoxyarylreste, Aryloxyarylreste, Halogenatome oder durch andere mehrfunktionelle Gruppen, beispielsweise durch endständige Säureesterfunktionen, substituiert sind oder in denen einzelne CH₂-Gruppen durch Sauerstoff- oder Schwefelatome, durch Gruppen wie -C(O)-O-, -C(O)-NR³-, -NR³-C(O)-NR⁴-, -O-C(O)-NR³-, -O-C(O)-O-, -NR³-, worin R³ und R⁴ die vorstehend beschriebene Bedeutung haben, ersetzt sein können.

Als besonders bevorzugte Reste R¹ sind 2-Phenylethyl, tert.-Butyl, n-Hexyl, 2,5-Dioxahexyl, Cyclopentyl, Cyclohexyl, Benzyl, Phenoxymethyl und Nonyl genannt. Insbesondere bevorzugt sind der tert.-Butyl-, Cyclohexyl- und der Phenoxymethylrest.

Die Herstellung der zur Umsetzung gemäß Schema 2 erforderlichen Alkohol-Sulfonsäureester der allgemeinen Formel IV kann auf unterschiedliche, in der Literatur bekannte, Verfahrensweisen erfolgen:
1) Entsprechend Schema 4 erfolgt die Umsetzung der mehrfunktionellen Alkohole der allgemeinen Formel VI mit entsprechenden Reagenzien unter Ausbildung partiell geschützter Alkohole der allgemeinen Formel VII. Die noch freie(n) Hydroxylgruppe(n) werden mit Sulfonsäurechloriden (Sulfonylchloriden) der allgemeinen Formel VIII unter Einfluß von Base zu den geschützten Alkohol-Sulfonsäureestern der allgemeinen Formel IX umgesetzt. Vollständige Entfernung der vorhandenen Schutzgruppen führt zu den mehrfunktionellen Alkohol-Sulfonsäureestern der allgemeinen Formel IV. Die Schutzgruppentechnik beschreibt T. W. Greene in "Protective Groups in Organic Synthesis", 1. Aufl., S. 10 - 113, Wiley & Sons, New York 1981, ausführlich anhand verschiedener Beispiele. 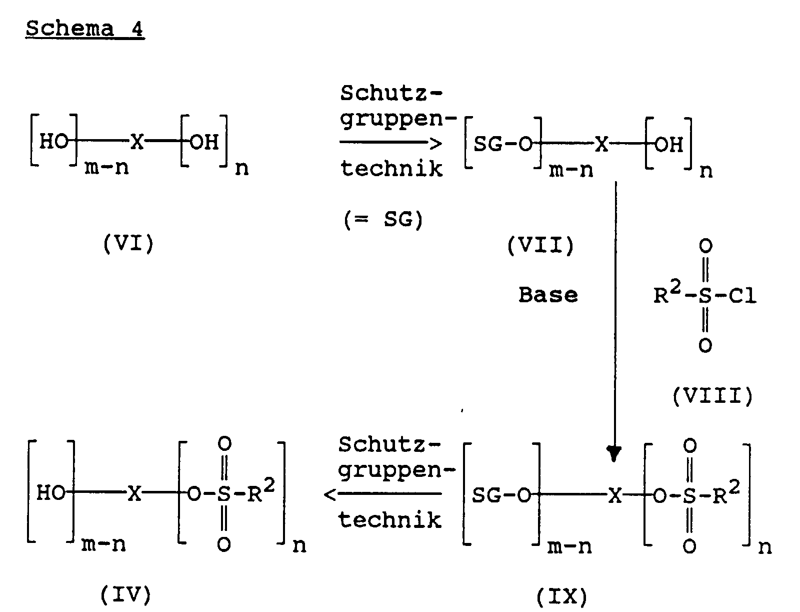
2) Entsprechend dem Schema 5 erfolgt die Umsetzung eines mehrwertigen Alkohols der allgemeinen Formel VI mit der gewünschten Menge eines monofunktionellen Sulfonsäurechlorids der allgemeinen Formel VIII zu mono- (m = 3, 4, 5), bis- (m = 6, 8) und trifunktionellen (m = 8) Sulfonsäureestern und/oder einem Isomerengemisch verschiedener sulfonsäureesterhaltiger Alkohole der allgemeinen Formel IV. Die Herstellung von Sulfonsäureestern (Sulfonaten) aus Alkoholen ist für monofunktionelle Verbindungen bekannt und wird beispielsweise von E. Schaumann in "Methoden der organischen Chemie" (Houben-Weyl-Müller, Eds.), 4. Aufl., Bd. 6/lb, S. 874, Thieme-Verlag,
   Stuttgart 1984, und dort zitierte Literatur) ausführlich beschrieben.

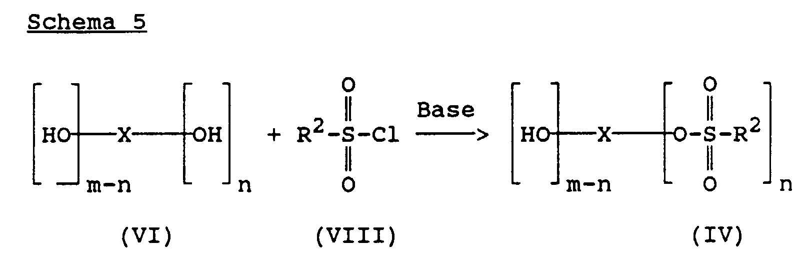

Bei der Reaktionsfolge nach Schema 4 wird der betreffende, mehrfunktionelle Alkohol der allgemeinen Formel VI mit der zum gewünschten Umsetzungsgrad erforderlichen Menge eines geeigneten Schutzgruppenreagenzes und einer katalytischen Menge einer Säure versetzt und man erhält partiell geschützte Alkohole der allgemeinen Formel VII. Art und Menge der verwendeten Schutzgruppenreagenzien richten sich nach der Struktur der mehrfunktionellen Alkohole VI. Die Säure und die gewählten Reaktionsbedingungen richten sich nach dem verwendeten Schutzgruppenreagenz. Da bei der Bildung der geschützten Sulfonsäureester der allgemeinen Formel IX Basen zur Deprotonierung eingesetzt werden, müssen die geschützten Alkohole der allgemeinen Formel VII basenstabil sein. Umsetzungsprodukte von Alkoholen mit schutzgruppenbildenden Reagenzien sind vor allem substituierte Methyl- und Ethylether, Silylether, Ester, Carbonate, cyclische Acetale und Ketale sowie cyclische Orthoester. Für Alkohole der allgemeinen Formel VI, die 1,2- oder 1,3-Hydroxylgruppen enthalten, kommen cyclische Acetale und Ketale sowie Orthoester in Frage. Bevorzugt sind Reagenzien, die zur Bildung cyclischer Ketale führen, wobei acetonid- (isopropyliden)geschützte 1,2- und 1,3-Alkohole besonders bevorzugt sind.

Acetonide (1,2- bzw. 1,3-O,O-Isopropylidenketale) können durch Umsetzung von 1,2- und 1,3-Alkoholen der allgemeinen Formel VI mit z. B. 2-Methoxypropen, 2-Ethoxypropen, 2-(Trimethylsilyloxy)propen, Aceton oder 2,2-Dimethoxypropan in Gegenwart katalytischer Mengen an Säure erhalten werden. Besonders bevorzugt ist die Umsetzung von Alkoholen, enthaltend 1,2- bzw. 1,3-Hydroxygruppen, in wasserfreiem Aceton, da hier das schutzgruppenbildende Reagenz gleichzeitig als Lösemittel fungiert.

Bei der Reaktionsfolge nach Schema 4 werden die verwendeten Alkohole, die 1,2- oder 1,3-Hydroxylgruppen enthalten, mit einer 2- bis 20fachen, bevorzugt 5- bis 12fachen, Menge an Aceton erwärmt. Gegebenenfalls können noch ein oder auch mehrere weitere Lösemittel zugesetzt werden, um eine bessere Löslichkeit zu erzielen oder die Reaktionsgeschwindigkeit entsprechend zu erhöhen. Nach Zugabe einer katalytischen Menge an Säure, bevorzugt p-Toluolsulfonsäure, wird die Mischung 1 bis 24 h, bevorzugt 3 bis 8 h bei 20 bis 85 °C, bevorzugt bei 35 bis 60 °C, gerührt und anschließend mit der 1- bis 10fachen, bevorzugt 2- bis 5fachen, Menge an Kaliumcarbonat (bezogen auf die eigesetzte Menge an p-Toluolsulfonsäure) oder einer anderen Base versetzt.

Nach dem Abkühlen können die meist trüben Mischungen über ein Trennhilfsmittel, wie Kieselgur, Kieselgel o. a., filtriert werden. Anschließend destilliert man das Lösemittel im Vakuum ab. Das Produkt wird nach den durch den Fachmann bekannten Methoden, z. B. durch Destillation im Hochvakuum, gereinigt.

Mehrfunktionelle Alkohole der allgemeinen Formel VI, die keine 1,2- bzw. 1,3-Hydroxygruppen aufweisen, werden besonders durch die Umwandlung in Ether geschützt. Dabei sind substituierte Methylether und Silylether bevorzugt. Besonders bevorzugt sind die Tetrahydropyranylether. Diese werden bevorzugt auf zwei verschiedene Weisen synthetisiert, die von A. Bongini, G. Cardillo, M. Orena, S. Sandri, Synthesis **1979**, 618 (Var. A) bzw. von M. Miyashita, A. Yoshikoshi, P. A. Grieco, J. Org. Chem. **42** (1977) 3772 (Var. B) beschrieben wurden.

### Variante A:

Bei der Reaktionsfolge nach Schema 4 werden die verwendeten Alkohole, die keine 1,2- oder 1,3-Hydroxylgruppen enthalten, mit einer dem gewünschten Umsetzungsgrad entsprechenden Menge an 3,4-Dihydro-2H-pyran in einer 1- bis 20fachen, bevorzugt 2- bis 10fachen, Menge Hexan gelöst und zu einer Suspension aus saurem Ionenaustauschharz (Amberlyst H-15, 0,05- bis 2fache, bevorzugt 0,1- bis 0,5fache Menge, bezogen auf die eingesetzte Menge an Hydroxylgruppen) in Hexan (Menge wie oben) gegeben. Gegebenenfalls können noch ein oder auch mehrere weitere Lösemittel, wie z. B. Methanol, zugesetzt werden, um eine bessere Löslichkeit zu erzielen. Die Mischung wird 0,5 bis 24 h, bevorzugt 1 bis 5 h bei 0 bis 85 °C, bevorzugt bei 20 bis 50 °C, gerührt und anschließend das Harz abfiltriert. Anschließend destilliert man das Lösemittel im Vakuum ab. Der verbleibende Rückstand, der praktisch ausschließlich die isomeren Alkohole enthält, wird durch Chromatographie aufgetrennt.

### Variante B:

Bei der Reaktionsfolge nach Schema 4 werden die verwendeten Alkohole, die keine 1,2- oder 1,3-Hydroxylgruppen enthalten, mit einer dem gewünschten Umsetzungsgrad entsprechenden Menge an 3,4-Dihydro-2H-pyran in einer 5- bis 300fachen, bevorzugt 20- bis 100fachen, Menge Dichlormethan gelöst und mit Pyridinium-p-Toluolsulfonat (0,02- bis 1,0fache, bevorzugt 0,05- bis 0,3fache, Molmenge, bezogen auf die Anzahl der umzusetzenden Hydroxylgruppen) versetzt. Gegebenenfalls können noch weitere Lösemittel zugesetzt werden. Anschließend wird die Mischung 0,5 bis 48 h, bevorzugt 2,5 bis 8 h, bei 0 bis 80 °C, bevorzugt bei 10 bis 45 °C, gerührt und anschließend mit der 5- bis 100fachen, bevorzugt 10- bis 50fachen, Menge Ether (bezogen auf die eingesetzte Lösemittelmenge) versetzt. Man wäscht mit partiell gesättigten Lösungen von Natriumchlorid und mit Wasser. Nach dem Trocknen mit Natriumsulfat wird das Lösemittel im Vakuum abdestilliert. Der verbleibende Rückstand, der praktisch ausschließlich die isomeren Alkohole enthält, wird durch Chromatographie aufgetrennt.

Der dem gewünschten Umsetzungsgrad entsprechende, partiell geschützte Alkohol der allgemeinen Formel VII wird nach beiden Varianten als Hauptprodukt erhalten.

Die noch freie(n) Hydroxylgruppe(n) der partiell geschützten Alkohole der allgemeinen Formel VII werden mit Sulfonsäurechloriden (Sulfonylchloriden) der allgemeinen Formel VIII unter Einfluß von Base umgesetzt. Man erhält die geschützten Alkohol-Sulfonsäureester der allgemeinen Formel IX.

Bei der Reaktionsfolge nach Schema 4 werden die partiell geschützten Alkohole der allgemeinen Formel VII mit einer 0,5- bis 40fachen, bevorzugt 2- bis 10fachen, Menge einer Base gelöst und 0,1 bis 10 h, bevorzugt 0,5 bis 1 h bei -40 bis 65 °C, bevorzugt bei -15 bis 25 °C, gerührt. Als Basen werden vor allem basische Amine, wie z. B. Pyridin, Triethylamin, N-Methylmorpholin u. a. bevorzugt, ganz besonders bevorzugt ist jedoch N-Methylmorpholin. Gegebenenfalls können noch ein oder auch mehrere weitere Lösemittel, wie z. B. Acetonitril, zugesetzt werden, um z. B. eine bessere Löslichkeit oder eine Erhöhung der Reaktionsgeschwindigkeit zu erzielen. Anschließend versetzt man die Mischung mit dem gewünschten Sulfonsäurechlorid VIII (1- bis 3fache, bevorzugt 1,05- bis 1,5fache, Menge, bezogen auf die im eingesetzten Alkohol noch vorhandenen Hydroxylgruppen) und rührt 0,5 bis 48 h, bevorzugt 2 bis 8 h bei -40 bis 65 °C, bevorzugt bei -15 bis 25 °C. Anschließend versetzt man die Mischung mit Dichlormethan/Wasser, wäscht die organische Phase, nach den durch den Fachmann bekannten Methoden, neutral, trocknet mit Natriumsulfat und destilliert das Lösemittel im Vakuum ab.

Obwohl die verbleibenden Rückstände hauptsächlich aus den partiell geschützten Alkohol-Sulfonsäureestern der allgemeinen Formel IX bestehen - und in der Regel ohne weitere Reinigung in der nächsten Stufe eingesetzt werden - kann das Produkt ggf. weiterhin nach den durch den Fachmann bekannten Methoden gereinigt werden.

Bei der Reaktionsfolge nach Schema 4 werden die Schutzgruppen der partiell geschützten Alkohol-Sulfonsäureester der allgemeinen Formel IX in Anwesenheit einer katalytischen Menge Säure vollständig entfernt. Man erhält die Alkohol-Sulfonsäureester der allgemeinen Formel IV. Art und Menge der verwendeten Säure richten sich nach der oben eingesetzten Schutzgruppe. So werden Acetonid-Schutzgruppen (O,O-Isopropylidenacetale) bevorzugt mit wäßrigen HCl-Lösungen unterschiedlicher Konzentration, mit Essigsäure, mit p-Toluolsulfonsäure und/oder durch den Einsatz saurer Ionenaustauschharze entfernt. Für die Spaltung der Tetrahydropyranylether in die entsprechenden Alkohole finden die gleichen Reagenzien Anwendung.

Bei der Spaltung der cyclischen Ether gemäß Schema 4 werden die partiell geschützten Alkohol-Sulfonsäureester der allgemeinen Formel IX in einer 5- bis 200fachen, bevorzugt 10- bis 50fachen, Menge eines Lösemittels gelöst und so lange mit wäßriger Salzsäure versetzt, bis der pH ≈ 1 ist. Als Lösemittel finden Alkohole, Ether, Wasser, organische Säuren, Ketone oder Mischungen dieser Solventien Verwendung. Bevorzugt sind Alkohole und Ether, wie z. B. Methanol oder Tetrahydrofuran, aber auch Mischungen, bestehend aus Tetrahydrofuran, Essigsäure oder verdünnter Salzsäure und Wasser. Besonders bevorzugt ist Methanol. Anschließend versetzt man mit einer katalytischen Menge p-Toluolsulfonsäure und rührt 1 bis 18 h, bevorzugt 2 bis 7 h bei -25 bis 80 °C, bevorzugt bei 0 bis 45 °C, gerührt. Anschließend stellt man durch Zugabe alkoholischer Kaliumhydroxid-Lösung den pH-Wert der Mischung auf schwach alkalisch ein (pH ≈ 8 bis 9) und destilliert das Lösemittel im Vakuum ab. Der Rückstand wird durch Säulenchromatographie an Kieselgel aufgetrennt, und man erhält die gewünschten Alkohol-Sulfonsäureester der allgemeinen Formel IV meist als farblose Verbindungen. Als Laufmittel für die Säulenchromatographie finden bevorzugt Dichlormethan, Essigester, Ether, Hexan, Petrolether verschiedener Siedefraktionen, Tetrahydrofuran, Trichlormethan und Gemische dieser Eluenten Verwendung. Besonders bevorzugt sind Dichlormethan und dessen Mischungen.

Entsprechend dem Schema 5 kann die Umsetzung eines mehrwertigen Alkohols der allgemeinen Formel VI, der keine 1,2- oder 1,3-Hydroxylgruppen enthält, mit Sulfonsäurechloriden auch ohne Schutzgruppentechnologie erfolgen. Dabei ergibt die Reaktion mit der gewünschten Menge eines monofunktionellen Sulfonsäurechlorids der allgemeinen Formel VIII mono- (m = 3, 4, 5), bis-(m = 6, 8) und trifunktionelle (m = 8) Sulfonsäureester und/oder ein Isomerengemisch verschiedener sulfonsäureesterhaltiger Alkohole der allgemeinen Formel IV.

Für diese Umsetzungen gelten die gleichen Bedingungen, wie sie für den Reaktionsschritt VII -> IX gemäß Schema 4 explizit erläutert wurden.

Als Alkohole der allgemeinen Formel VI können tri-, tetra- oder höherfunktionelle Alkohole Verwendung finden; bevorzugt sind Alkohole, die 3 bis 6 OH-Gruppen pro Molekül enthalten.

Trifunktionelle Alkohole leiten sich bevorzugt vom Glycerin, von höheren α,β,ω-Triolen oder vom Triethanolamin ab, wobei auch hier höherkettige Derivate, insbesondere ethoxylierte Verbindungen, wie z. B. 1,3,5-Tris(2-hydroxyethyl)cyanursäure gleichermaßen Verwendung finden können. Genannt werden Glycerin, 2-Hydroxymethyl-2-methyl-propan-1,3-diol, 2-Ethyl-2-hydroxymethyl-propan-1,3-diol, 2,3-Isopropyliden-erythruronsäure, Hexan-1,2,6-triol, 1,1,1-Triethanolamin, 1,1,1-Tripropanolamin sowie partiell acetalisierte oder ketalisierte Zuckerderivate.

Darüber hinaus lassen sich auch Umsetzungsprodukte aus tetrafunktionellen Alkoholen oder Aminotriolen mit Säurederivaten, Isocyanaten oder cyclischen Carbonaten verwenden. Höherwertige Alkohole der allgemeinen Formel VI leiten sich beispielsweise von Kondensationsprodukten des Glycerins, des Pentaerythrits oder von Umsetzungsprodukten bifunktioneller Säurederivate oder Isocyanate mit höherwertigen Alkoholen oder Aminoalkoholen ab.

Die Liste der verwendbaren Alkohole ist damit durchaus nicht vollständig; es lassen sich praktisch alle Alkohole verwenden, die keine weitere mit Säureestern reagierende Gruppe aufweisen oder die unter den beschriebenen Umsetzungsbedingungen eindeutig unter Esterbildung reagieren.

Bei der Herstellung von β-Ketoester-Sulfonsäureestern der allgemeinen Formel II durch Umesterung gemäß Schema 3 werden monofunktionelle β-Ketoester der allgemeinen Formel V mit Alkohol-Sulfonsäureestern der allgemeinen Formel IV in der Weise eingesetzt, daß ein 5 bis 200%iger, bevorzugt ein 10 bis 50%iger, Überschuß eines mit einem niedermolekularen Alkohol veresterten β-Ketoesters, z.B. eines Methyl- oder Ethylesters, bei 100 bis 160 °C, bevorzugt bei 120 bis 140 °C, umgesetzt wird. Zur Erhöhung der Löslichkeit des Alkohol-Sulfonsäureesters der allgemeinen Formel IV im β-Ketoester der allgemeinen Formel V kann ggf. ein Lösungsvermittler, wie Dimethylformamid oder N-Methylpyrrolidon, zugesetzt werden. Durch Anlegen eines schwachen Vakuums von 800 bis 20 Torr, bevorzugt von 400 bis 100 Torr, wird das Gleichgewicht durch Abdestillieren des gebildeten niederen Alkohols kontinuierlich in die gewünschte Richtung verschoben. Nachdem die theoretische Menge an niederem Alkohol abdestilliert ist, wird der überschüssige, niedrig veresterte β-Ketoester der allgemeinen Formel V sowie ggf. der zugefügte Lösungsvermittler im Hochvakuum abdestilliert. Als Rückstand verbleibt der häufig ölig anfallende β-Ketoester-Sulfonsäureester der allgemeinen Formel II in zumeist sehr hoher Reinheit, so daß er ohne weitere Reinigung für den Diazotransfer verwendet werden kann.

Die bei dieser Reaktionsfolge erforderlichen niedrig veresterten β-Ketoester der allgemeinen Formel V sind z. T. kommerziell verfügbar oder lassen sich nach zahlreichen literaturbekannten Methoden herstellen. Besonders bevorzugt ist dabei ihre Herstellung aus den entsprechenden Derivaten der 5-Acyl-meldrumsäure der allgemeinen Formel III. Obwohl hierbei ein zusätzlicher Reaktionsschritt gegenüber der Verfahrensvariante 1 beschritten wird, lassen sich mit dieser Variante verbesserte Ausbeuten und/oder reinere β-Ketoester-Sulfonsäureester der allgemeinen Formel II erzielen.

Das erfindungsgemäße strahlungsempfindliche Gemisch kann eine oder mehrere Verbindungen der allgemeinen Formel I enthalten, die α-Diazo-β-ketoester- und Sulfonsäureester-Einheiten, insbesondere im gleichen Anteil, enthalten. Bevorzugt ist allerdings, wenn lediglich eine photoaktive Verbindung im Gemisch enthalten ist. Die Konzentration der α-Diazo-β-ketoesterester- und Sulfonsäureester-Einheiten enthaltenden Verbindung der allgemeinen Formel I im erfindungsgemäßen strahlungsempfindlichen Gemisch kann sich in weiten Grenzen bewegen. Im allgemeinen liegt aber dessen Konzentration im Bereich von 4 bis 40 Gew.-%, insbesondere bei 10 bis 35 Gew.-%, bezogen auf die nichtflüchtigen Bestandteile des strahlungsempfindlichen Gemisches.

Das erfindungsgemäße strahlungsempfindliche Gemisch enthält ferner mindestens ein polymeres, in Wasser unlösliches, in wäßrig-alkalischen Lösungen aber lösliches, zumindest aber quellbares Bindemittel. Das Bindemittel zeichnet sich im besonderen dadurch aus, daß es mit den übrigen Bestandteilen des erfindungsgemäßen strahlungsempfindlichen Gemisches gut verträglich ist und insbesondere im Wellenlängenbereich von 190 bis 300 nm eine möglichst geringe Eigenabsorption, d.h. eine hohe Transparenz, aufweist. Hierunter fallen insbesondere nicht diejenigen Bindemittel auf der Basis von Novolak-Kondensationsharzen, die in der Regel in Kombination von Naphthochinondiaziden als photoaktive Komponenten eingesetzt worden sind. Zwar lassen Novolak-Kondensationsharze nach bildmäßiger Belichtung in den nicht belichteten Bereichen eine Erniedrigung der Löslichkeit gegenüber wäßrig-alkalischen Entwicklern erkennen, doch ist ihre Eigenabsorption in dem für die Belichtung gewünschten Wellenlängenbereich unerwünscht hoch.

Die genannten Novolak-Kondensationsharze können jedoch in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des p-Hydroxystyrols sowie seiner Alkylderivate, z. B. des 3-Methylhydroxystyrols, sowie Homo- oder Copolymere anderer Polyvinylphenole, z. B. des 3-Hydroxystyrols, oder die Ester oder Amide von Acrylsäure mit phenolische Gruppen aufweisenden Aromaten. Als Comonomere im Copolymeren können polymerisierbare Verbindungen wie Styrol, Methylmethacrylat, Methylacrylat oder ähnliche eingesetzt werden.

Gemische mit erhöhter Plasmabeständigkeit werden dann erhalten, wenn zur Herstellung von Copolymeren des obigen Typs Silicium enthaltende Vinylmonomere, z.B. Vinyltrimethylsilan, verwendet werden. Die Transparenz dieser Bindemittel ist im interessierenden Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im beschriebenen Wellenlängenbereich. Als Comonomere werden auch hier bevorzugt Styrol, substituierte Styrole, Vinylether, Vinylester, Vinylsilylverbindungen oder (Meth)acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierunter zählen beispielsweise Maleinsäureanhydrid, Maleinsäurehalbester oder dergleichen.

Die genannten Bindemittel können in Mischungen auftreten, sofern sie mischbar sind und die optischen Qualitäten des strahlungsempfindlichen Gemisches nicht verschlechtern. Bevorzugt sind jedoch Bindemittel, enthaltend einen Typus der obengenannten Arten.

Das erfindungsgemäße strahlungsempfindliche Gemisch enthält 60 bis 96 Gew.-%, insbesondere 65 bis 94 Gew.-% eines Bindemittels, bezogen auf den Anteil der nichtflüchtigen Bestandteile des strahlungsempfindlichen Gemisches.

Ferner können dem erfindungsgemäßen strahlungsempfindlichen Gemisch ggf. Farbstoffe, Pigmente, Netzmittel, Haftvermittler und Verlaufmittel zur Verbesserung spezieller Erfordernisse wie Flexibilität, Haftung und Glanz zugesetzt werden.

Vorzugsweise wird das erfindungsgemäße strahlungsempfindliche Gemisch in Lösemitteln wie Ethylenglykol, Glykolethern (wie Glykolmonomethylether, Glykoldimethylether, Glykolmonoethylether oder Propylenglykolmonoalkylethern, insbesondere Propylenglykolmethylether), aliphatischen Estern (wie Ethylacetat, Hydroxyethylacetat, Alkoxyethylacetat, τButylacetat, Propylenglykolmonoalkyletheracetat, insbesondere Propylenglykolmethyletheracetat oder Amylacetat), Ethern (wie Dioxan), Ketonen (wie Methylethylketon, Methylisobutylketon, Cyclopentanon und Cyclohexanon), Dimethylformamid, Dimethylacetamid, Hexamethylphosphorsäureamid, N-Methylpyrrolidon, Butyrolacton, Tetrahydrofuran und in Mischungen derselben gelöst. Besonders bevorzugt werden Glykolether, aliphatische Ester sowie Ketone. Darüber hinaus können Lösemittelgemische Anwendung finden, die u.a. auch aromatische Kohlenwasserstoffe oder Xylol enthalten. Letztendlich hängt die Wahl der Lösemittel von dem angewandten Beschichtungsverfahren, der gewünschten Schichtstärke und den Trocknungsbedingungen ab. Ebenso müssen die Lösemittel chemisch neutral sein, d.h. sie dürfen nicht mit den übrigen Schichtkomponenten irreversibel reagieren.

Die mit den übrigen Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen bestehend aus einem Substrat und dem darauf aufgetragenen strahlungsempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus reinen Siliciumschichten und thermisch oxidiertem und/oder mit Aluminium beschichtetem Siliciummaterial zu nennen, die gegebenenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und - folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete SiO₂-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Substrat einen Haftvermittler enthalten. Bei Silicium- bzw. SiliciumdioxidSubstraten kommen hierfür Haftvermittler vom Aminosilantyp, wie z.B. 3-Aminopropyltriethoxysilan oder Hexamethyl-disilazan in Frage.

Beispiele für Träger, die zur Herstellung von photomechanischen Aufzeichnungsschichten wie Druckformen für den Hochdruck, den Flachdruck, den Siebdruck, den Tiefdruck sowie von Reliefkopien Verwendung finden können, sind Aluminiumplatten, ggf. anodisch oxidiert, gekörnte und/oder silikatisierte Aluminiumplatten, Zinkplatten, Stahlplatten, die ggf. mit Chrom bearbeitet wurden, sowie Kunststoffolien oder Papier.

Das erfindungsgemäße Aufzeichnungsmaterial wird bildmäßig belichtet. Quellen aktinischer Strahlung sind: Metallhalogenid-, Kohlebogen-, Xenon- und Quecksilberdampflampen. Ebenso kann eine Belichtung mit energiereicher Strahlung wie Laser-, Elektronen oder Röntgenstrahlung erfolgen. Besonders bevorzugt sind jedoch Lampen, die Licht einer Wellenlänge von 190 bis 260 nm ausstrahlen können, d.h. insbesondere Xenon- oder/und Quecksilberdampflampen. Darüber hinaus lassen sich auch Laserlichtquellen verwenden, z.B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen, andererseits aber auch für aktinisches Licht des genannten Bereiches genügend durchlässig sein.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Walzen, Rakeln, Gießen, durch Fließbeschichten, Schleuderbeschichten und Tauchbeschichten oder mittels Breitschlitzdüsen erfolgen. Danach wird das Lösemittel durch Verdampfen entfernt, so daß auf der Oberfläche des Substrates die strahlungsempfindliche Schicht zurückbleibt. Die Entfernung des Lösemittels kann gegebenenfalls durch Erhitzen der Schicht auf Temperaturen von bis zu 140 °C gefördert werden. Das Gemisch kann aber auch zunächst auf obengenannte Weise auf den Zwischenträger aufgetragen werden, von dem aus es unter Druck und erhöhter Temperatur auf das endgültige Trägermaterial übertragen wird.

Die Schichtstärke variiert in Abhängigkeit von ihrem Einsatzgebiet. Sie beträgt zwischen 0,1 und 100 µm, insbesondere zwischen 0,3 und 10 µm.

Anschließend wird die Schicht bildmäßig belichtet. Üblicherweise wird aktinische Strahlung verwendet. Zur Bestrahlung werden bevorzugt UV-Lampen verwendet, die Licht einer Wellenlänge von 190 bis 300 nm aussenden. In der strahlungsempfindlichen Schicht wird anschließend durch Entwicklung ein Bildmuster freigelegt, indem die Schicht mit einer Entwicklungslösung behandelt wird, die die bestrahlten Bereiche des Materials löst bzw. entfernt.

Als Entwickler werden Lösungen von Reagenzien wie z.B. Silikaten, Metasilikaten, Hydroxiden, Hydrogen- bzw. Dihydrogenphosphaten, Carbonaten bzw. Hydrogencarbonaten, von Alkali und/oder Erdalkali, insbesondere von Ammoniumionen, aber auch Ammoniak und dergleichen verwendet. Metallionenfreie Entwickler werden in den US-A 4 729 941, US-A 4 628 023 und 4 141 733 sowie den EP-A 0 097 282, 0 062 733 und 0 023 758 beschrieben. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung. metallionenfreie Entwickler werden insbesondere verwendet. Den Entwicklern können ggf. geringere Mengen eines Netzmittels zugesetzt sein, um die Ablösung der belichteten Stellen im Entwickler zu erleichtern.

Die entwickelten Resiststrukturen werden ggf. nachgehärtet. Dies geschieht im allgemeinen dadurch, daß man die Resiststruktur auf einer hot plate bis zu einer Temperatur unter der Fließtemperatur erhitzt und anschließend mit UV-Licht einer Xenon-Quecksilberdampflampe (Bereich von 200 bis 250 nm) ganzflächig belichtet. Durch diese Nachhärtung werden die Resiststrukturen vernetzt, so daß die Strukturen eine Fließbeständigkeit im allgemeinen bis zu Temperaturen von über 200 °C aufweisen. Die Nachhärtung kann auch ohne Temperaturerhöhung unter Einstrahlung von UV-Licht erfolgen. Dies gilt insbesondere dann, wenn energiereiche Strahlung verwendet wird, z.B. Elektronenstrahlung.

Bevorzugte Anwendung findet das erfindungsgemäße strahlungsempfindliche Gemisch in lithographischen Prozessen zur Herstellung integrierter Schaltungen oder von diskreten elektrischen Bausteinen. Das aus dem Gemisch hergestellte Aufzeichnungsmaterial dient dabei als Maske für die folgenden Prozeßschritte. Hierunter zählen z. B. das Ätzen des Schichtträgers, die Implantation von Ionen in den Schichtträger oder die Abscheidung von Metallen oder anderen Materialien auf den Schichtträger.

Die erfindungsgemäßen Gemische zeigen unter den praxisüblichen Bedingungen bei Belichtung im DUV-Bereich gegenüber den bekannten Materialien eine vergleichbare hohe Lichtempfindlichkeit (Vergleichsbeispiel s.u.), wenn sie mit Licht einer Wellenlänge von 190 bis 300 nm bestrahlt werden. Als Vorteile zeigen sie jedoch eine höhere thermische Stabilität als die bekannten Materialien sowie eine hervorragende Kompatibilität.

Die folgenden Beispiele erläutern die Herstellung der mehrfunktionellen Verbindungen der allgemeinen Formel I, die α-Diazoketoester- und Sulfonsäureester-Einheiten im Molekül enthalten.

### Anwendungsbeispiele

Die folgenden Beispiele geben einige Anwendungsmöglichkeiten der erfindungsgemäßen strahlungsempfindlichen Gemische wieder. Diese sollen lediglich erläuternden Charakter haben. In den Beispielen verhalten sich Gewichtsteile (Gt) zu Volumenteilen (Vt) bzw. g:cm3 wie 1:1.

### Beispiel 1

Es wird ein strahlungsempfindliches Gemisch hergestellt, enthaltend
- 0,19 Gt: 4-Bromphenylsulfonsäureester des 1,2,10,11-Tetra(4-cyclohexyl-3-diazo-2,4-dioxo-1-oxabutyl)triglycerins (Beispiel 10 der EP-A 456 073 und
- 0,75 Gt: Poly-(3-methyl-4-hydroxystyrol) in
- 4,25 Gt: Propylenglykolmonomethyletheracetat.

Von dieser Lösung werden 1,5 ml durch einen Filter mit einem Porendurchmesser von 0,2 µm filtriert und auf einen Siliciumwafer mit einem Durchmesser von 7,62 cm aufgetragen. Durch Rotation des Wafers bei 3.000 Upm für 45 s wird eine homogene Schicht erzeugt, die nach ihrem Trocknen in einem Umluftofen bei 90 °C und für 30 min eine Dicke von 1,03 µm aufweist.

Der in dieser Weise beschichtete Wafer wird durch eine Photomaske hindurch mit der UV-Strahlung einer XenonQuecksilberdampflampe bei 260 nm mit einer Energie von 170 mJ/cm2 bildmäßig bestrahlt.

Anschließend wird die bildmäßig bestrahlte Schicht mit einer 0,23 n wäßrigen Lösung von Tetramethylammoniumhydroxid für 80 s entwickelt. Der Abtrag der Schicht in den unbelichteten Bereichen (Dunkelabtrag) war kleiner als 10 nm. Die Löslichkeitsrate (Verhältnis der Abtragsgeschwindigkeit der belichteten Resistbereiche zum Dunkelabtrag) lag bei etwa 13. Strukturen, auch mit Dimensionen von kleiner als 1,0 µm, waren bei guter Kantenstabilität sauber aufgelöst.

### Beispiel 2

Es wird ein strahlungsempfindliches Gemisch hergestellt, enthaltend
- 0,28 Gt: 2-(Benzoylaminomethyl)thiophen-5-sulfonsäureester des 2,10-Diazo-1,11-dicyclohexyl-4,8-dioxa-6-ethyl-6-(hydroxymethyl)-1,3,9,11-tetraoxoundecans (Beispiel 2 der EP-A 456 073 und
- 0,75 Gt: Poly-(3-methyl-4-hydroxystyrol) in
- 4,25 Gt: Propylenglykolmonomethyletheracetat.

Von dieser Lösung wird unter Verwendung der Angabe aus Beispiel 1 ein strahlungsempfindliches Gemisch hergestellt. Analog zu Beispiel 1 wird belichtet und entwickelt. Für die Belichtung wird allerdings eine Belichtungsenergie von 210 mJ/cm2 angewendet. Es konnten kantenscharfe Strukturen erhalten werden. Das Löslichkeitsratenverhältnis wurde zu 16 bestimmt.

### Beispiel 3

Es wird ein strahlungsempfindliches Gemisch hergestellt, enthaltend
- 0,28 Gt: 3-Phenylpropylsulfonsäureester des 1,11-Diadamantyl-2,10-diazo-4,8-dioxa-6-(hydroxymethyl)6-methyl-1,3,9,11-tetraoxoundecans (Beispiel 8 der EP-A 456 073) und
- 0,75 Gt: Poly-(3-methyl-4-hydroxystyrol) in
- 4,25 Gt: Propylenglykolmonomethyletheracetat,
und entsprechend dem Beispiel 2 weiterverarbeitet. Bei einer bildmäßigen Bestrahlung mit einer Energie von 170 mJ/cm2 konnten kantenscharfe Strukturen erhalten werden. Das Löslichkeitsratenverhältnis war etwa 13.

### Beispiel 4

Es wird ein strahlungsempfindliches Gemisch hergestellt, enthaltend
- 0,25 Gt: 4-tert.-Butylphenylsulfonsäureester des 2,10-Diazo-1,11-dicyclohexyl-4,8-dioxa-6-ethyl-6(hydroxymethyl)-1,3 9,11-tetraoxoundecans (Beispiel 1 der EP-A 456 073) und
- 0,75 Gt: Poly-(3-methyl-4-hydroxystyrol) in
- 4,25 Gt: Propylenglykolmonomethyletheracetat.

Von dieser Lösung werden 1,5 ml durch einen Filter mit einem Porendurchmesser von 0,2 µm filtriert und auf einen Siliciumwafer mit einem Durchmesser von 7,62 cm aufgetragen. Durch Rotation des Wafers bei 3.000 Upm für 45 s wird eine homogene Schicht erzeugt, die nach ihrem Trocknen in einem Umluftofen bei 90 °C und für 30 min eine Dicke von 0,88 µm aufweist.

Der in dieser Weise beschichtete Wafer wird durch eine Photomaske hindurch mit der UV-Strahlung einer Xenon-Quecksilberdampflampe bei 260 nm mit einer Energie von 150 mJ/cm2 bildmäßig bestrahlt.

Anschließend wird die bildmäßig bestrahlte Schicht mit einer 0,27 n wäßrigen Lösung von Tetramethylammoniumhydroxid für 90 s entwickelt. Der Abtrag der Schicht in den unbelichteten Bereichen (Dunkelabtrag) war kleiner als 20 nm. Die Löslichkeitsrate (Verhältnis der Abtragsgeschwindigkeit der belichteten Resistbereiche zum Dunkelabtrag) lag bei etwa 14. Auch Strukturen mit Dimensionen von kleiner als 1,0 µm waren diese bei guter Kantenstabilität sauber aufgelöst.

### Beispiel 5

Es wird ein strahlungsempfindliches Gemisch hergestellt, enthaltend
- 0,19 Gt: 4-Bromphenylsulfonsäureester des 1,2,10,11-Tetra(4-cyclohexyl-3-diazo-2,4-dioxo-1-oxabutyl)triglycerins (Beispiel 10 der EP-A 456 073) und
- 0,55 Gt: Poly-(styrol-co-maleinimid) (1:1) in
- 4,25 Gt: Cyclohexanon.

1,5 ml dieser Lösung werden mittels eines Filters mit einem Porendurchmesser von 0,2 µm filtriert und auf einen mit 2.800 Upm rotierenden Siliciumwafer mit einem Durchmesser von 7,62 cm aufgetragen. Nach 45 s kann eine homogene Schicht erhalten werden. Nach dem Trocknen der Schicht bei 90 °C und für 30 min beträgt die Schichtdicke der homogenen strahlungsempfindlichen Schicht 0,98 µm.

Bei einer Wellenlänge von 260 nm wird der beschichtete Wafer anschließend durch eine Photomaske hindurch bildmäßig belichtet. Als UV-Strahlungsquelle wird eine Xenon-Quecksilberdampflampe verwendet. Die Belichtungsenergie beträgt 160 mJ/cm2.

Mit einer 0,02 n wäßrigen Lösung von Tetramethylammoniumhydroxid konnte die Schicht anschließend innerhalb von 60 s einwandfrei entwickelt werden. Der Dunkelabtrag war kleiner als 30 nm und zudem wurde eine hinreichende Differenzierung zwischen belichteten und unbelichteten Resistbereichen beobachtet (Verhältnis der Löslichkeitsraten = 15).

### Beispiele 6 bis 15

Analog zu Beispiel 5, jedoch unter Verwendung der im Folgenden aufgeführten photoaktiven Verbindungen, wurden strahlungsempfindliche Gemische hergestellt und verarbeitet. In allen Fällen wurde eine gute Differenzierung zwischen belichteten und unbelichteten Bereichen erhalten, die eine hohe Auflösung ergab.

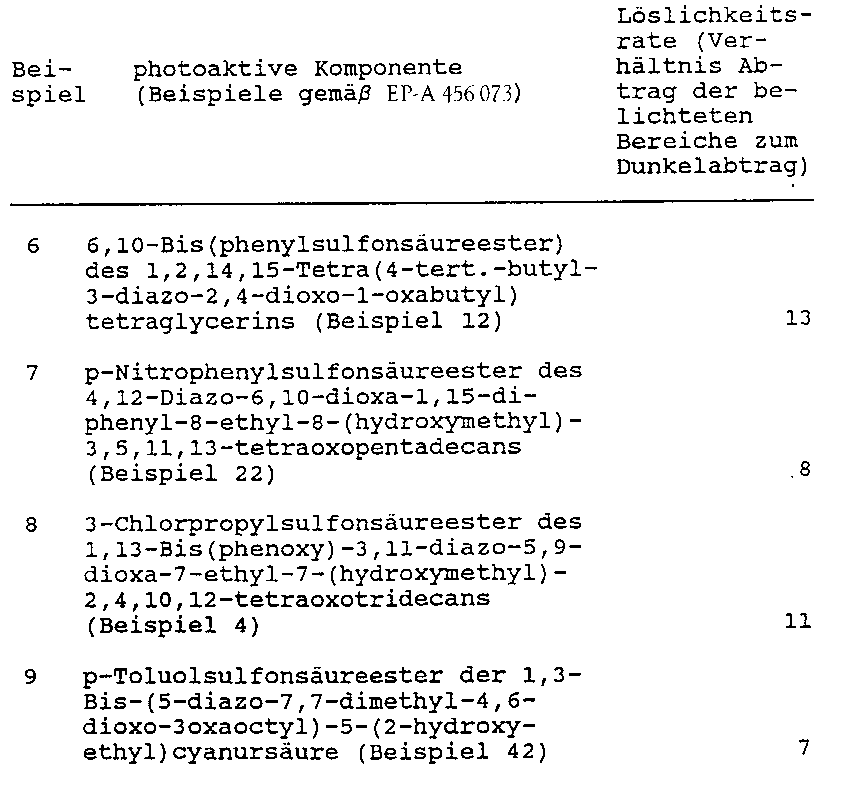

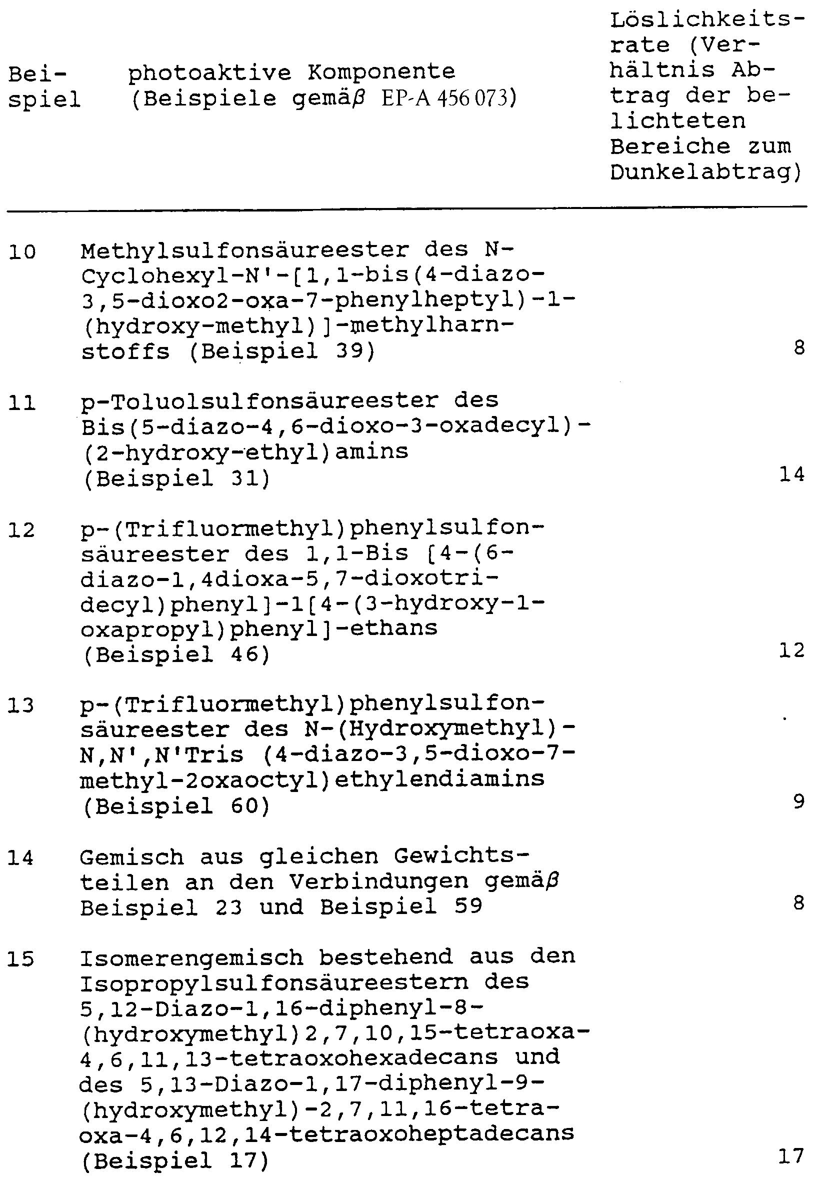

### Beispiel 16

Es wird ein strahlungsempfindliches Gemisch hergestellt, enthaltend
- 0,19 Gt: der Verbindung aus dem Beispiel 69 der EP-A 456 073 und
- 0,55 Gt: Poly-(styrol-co-maleinimid) (1:1) in
- 4,25 Gt: Cyclohexanon.

Von der Lösung werden 1,5 ml durch einen Filter mit einem Porendurchmesser von 0,2 µm auf einen Siliciumwafer mit einem Durchmesser von 7,62 cm aufgeschleudert und durch Rotation des Wafers bei 3.200 Upm innerhalb von 45 s eine homogene Schicht erzeugt. Die Schichtdicke nach dem Trocknen bei 90 °C für 30 min in einem Umluftofen beträgt 0,97 µm.

Der beschichtete Wafer wird durch eine Photomaske hindurch mit UV-Strahlung einer Xenon-Quecksilberdampflampe im Bereich von 260 nm mit einer Belichtungsenergie von 150 mJ/cm2 bestrahlt. Anschließend wird mit einer 0,24 n wäßrigen Lösung von Tetraethylammoniumhydroxid innerhalb von 60 s entwickelt. Der Dunkelabtrag war kleiner als 50 nm/min. Bei Anwendung einer Belichtungsenergie von 122 mJ/cm2 konnten 1 µm-Strukturen sauber und kantenscharf aufgelöst werden. Dabei waren die unbelichteten Bereiche 18mal schlechter löslich als die belichteten Bereiche.

### Beispiel 17 (Vergleichsbeispiel)

Es wird ein strahlungsempfindliches Gemisch hergestellt, enthaltend
- 0,19 Gt: der Verbindung (54) aus dem Vergleichsbeispiel 73 der EP-A-456073 und
- 0,55 Gt: Poly-(styrol-co-maleinimid) (1:1) in
- 4,25 Gt: Cyclohexanon.

Das Gemisch wird analog zu Beispiel 16 verarbeitet. Es konnte allerdings festgestellt werden, daß nach einer Entwicklungszeit von 60 s mit dem gleichen Entwickler aus Beispiel 16 die belichteten Bereiche vollständig entfernt worden waren. Die unbelichteten Bereiche waren ebenfalls nahezu vollständig entfernt. Der Abtrag der unbelichteten Bereiche (Dunkelabtrag) lag mit 860 nm/min in der gleichen Größenordnung wie die Abtragsrate für die belichteten Bereiche (2.360 nm/min). Das Löslichkeitsverhältnis (Löslichkeit im belichteten Bereich/Löslichkeit im unbelichteten Bereich) war mit 2,7 zu niedrig, um senkrechte Flanken zu erzeugen. Lediglich bei Anwendung der Entwicklungszeit von 20 s konnten Strukturen, allerdings mit sehr flachen Kanten, erzeugt werden.

## Patentansprüche

1. Positiv arbeitendes strahlungsempfindliches Gemisch, enthaltend im wesentlichen eine photoaktive Komponente und ein in Wasser unlösliches, in wäßrig alkalischer Lösung lösliches, zumindest aber quellbares Bindemittel, dadurch gekennzeichnet, daß als photoaktive Komponente eine Verbindung mit α-Diazo-β-ketoester und Sulfonsäureester-Einheiten der allgemeinen Formel I verwendet wird 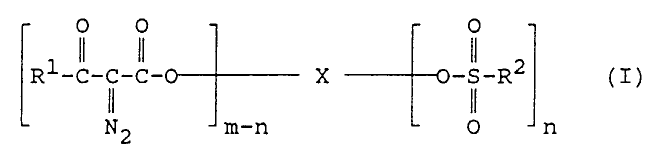 worin
R¹ einen aliphatischen, cycloaliphatischen, araliphatischen oder aromatischen Rest mit 4 bis 20 Kohlenstoffatomen, wobei einzelne CH₂-Gruppen durch Sauerstoff- oder Schwefelatome oder durch -NR³- oder NH-Gruppen ersetzt sein können und/oder Ketogruppen enthalten,
X einen aliphatischen, cycloaliphatischen, carbocyclischen, heterocyclischen oder araliphatischen Rest mit 2 bis 22 Kohlenstoffatomen, wobei einzelne CH₂-Gruppen durch Sauerstoff- oder Schwefelatome oder durch die Gruppen -NR³-, -C(O)-O-, -C(O)-NR³-, 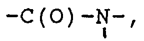 -NR³-C(O)-NR⁴-, -O-C(O)-NR³-, 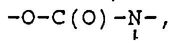 -O-C(O)-O- oder CH-Gruppen durch 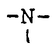 ersetzt sein können, worin
R² einen aliphatischen Rest mit 1 bis 8 Kohlenstoffatomen, in denen CH₂-Gruppen durch Sauerstoffatome oder NH-Gruppen ersetzt und/oder Ketogruppen enthalten sein können, oder einen der für R¹ angegebenen Reste,
R³ und R⁴ voneinander unabhängig für Wasserstoff oder einen aliphatischen, carbocyclischen oder araliphatischen Rest stehen,
m eine ganze Zahl von 3 bis 8 und
n eine ganze Zahl von 1 bis 3
bedeuten.

2. Positiv arbeitendes strahlungsempfindliches Gemisch nach Anspruch 1, dadurch gekennzeichnet, daß R³ und R⁴ Wasserstoff, (C₁-C₃)Alkyl, (C₆-C₁₂)Aryl oder (C₆-C₁₁)Aralkyl, insbesondere (C₁-C₃)Alkyl oder Wasserstoff bedeuten, wobei diese, insbesondere Aryl oder Aralkyl, am Kern durch (C₁-C₃)Alkyl, (C₁-C₃)-Alkoxy, Halogen, insbesondere Chlor oder Brom, oder Amino substituiert sein können.

3. Positiv arbeitendes strahlungsempfindliches Gemisch nach den Ansprüchen 1 oder 2, dadurch gekennzeichnet, daß R¹, R² und/oder X substituiert sind durch (C₁-C₃)Alkyl, (C₁-C₃)Alkoxy, Halogen, Amino oder Nitrilo, insbesondere durch (C₁-C₃)Alkyl oder (C₁-C₃)Alkoxy.

4. Positiv arbeitendes strahlungsempfindliches Gemisch nach einem oder mehreren der Ansprüche 1 bis 3, dadurch gekennzeichnet, daß sofern R¹ und R² einen aliphatischen Rest darstellt und dieser substituiert ist, dieser insbesondere 4 bis 10 Kettenglieder aufweist.

5. Positiv arbeitendes strahlungsempfindliches Gemisch nach Anspruch 4, dadurch gekennzeichnet, daß CH₂-Gruppen insbesondere durch Sauerstoffatome, -NH-Gruppen oder Ketogruppen ersetzt sind und diese Reste daher Ether-, Keto-, Ester-, Amido- und/oder Imidogruppen enthalten.

6. Positiv arbeitendes strahlungsempfindliches Gemisch nach einem oder mehreren der Ansprüche 1 bis 3, dadurch gekennzeichnet, daß sofern R¹ einen aliphatischen Rest darstellt und dieser unsubstituiert ist, dieser bis zu 20 Kettenglieder aufweist.

7. Positiv arbeitendes strahlungsempfindliches Gemisch nach einem oder mehreren der Ansprüche 1 bis 3, dadurch gekennzeichnet, daß R¹ und/oder R² einen cycloaliphatischen Rest bedeutet mit 4, 5, 6 oder 12, insbesondere 4, 5 oder 6, besonders bevorzugt 6, Ringgliedern, und der insbesondere unsubstituiert ist.

8. Positiv arbeitendes strahlungsempfindliches Gemisch nach einem oder mehreren der Ansprüche 1 bis 3, dadurch gekennzeichnet, daß R¹ und/oder R² ein araliphatischer Rest ist mit 2 bis 11, insbesondere 2 bis 5, Kettengliedern im aliphatischen Teil des Restes.

9. Positiv arbeitendes strahlungsempfindliches Gemisch nach Anspruch 8, dadurch gekennzeichnet, daß der aliphatische Teil des Restes R¹ und/oder R² 1 oder 2 Kettenglieder enthält, sofern dieser Teil eine reine Kohlenstoffkette aufweist.

10. Positiv arbeitendes strahlungsempfindliches Gemisch nach Anspruch 8, dadurch gekennzeichnet, daß der aliphatische Teil des Restes R¹ 3 bis 5 Kettenglieder aufweist, sofern in diesem Teil CH₂-Gruppen durch Heteroatome ersetzt sind.

11. Positiv arbeitendes strahlungsempfindliches Gemisch nach Anspruch 8, dadurch gekennzeichnet, daß der Rest R² 1 bis 8 Kettenglieder aufweist, sofern dieser Teil aliphatisch und unsubstituiert ist.

12. Positiv arbeitendes strahlungsempfindliches Gemisch nach einem oder mehreren der Ansprüche 1 bis 11, dadurch gekennzeichnet, daß im Rest X maximal 5, insbesondere maximal 3 CH₂-Gruppen durch die Heteroatome bzw. die genannten Gruppen ersetzt sind.

13. Positiv arbeitendes strahlungsempfindliches Gemisch nach einem oder mehreren der Ansprüche 1 bis 11, dadurch gekennzeichnet, daß der Rest X aliphatisch und unsubstituiert ist und maximal 6 Kohlenstoffatome aufweist.

14. Positiv arbeitendes strahlungsempfindliches Gemisch nach Anspruch 13, dadurch gekennzeichnet, daß dieser maximal eine C-C-Mehrfachbindung aufweist.

15. Positiv arbeitendes strahlungsempfindliches Gemisch nach Anspruch 12, dadurch gekennzeichnet, daß die CH₂-Gruppen ersetzenden Heteroatome von einem Typ sind.

16. Positiv arbeitendes strahlungsempfindliches Gemisch nach Anspruch 12, dadurch gekennzeichnet, daß sofern eine CH-Gruppe durch 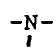 ersetzt ist, keine weitere Substitution im Rest X vorliegt.

17. Positiv arbeitendes strahlungsempfindliches Gemisch nach Anspruch 12, dadurch gekennzeichnet, daß X ein cycloaliphatischer Rest ist, in dem der cycloaliphatische Teil unsubstituiert ist und benachbart ist einer CH₂-Gruppe des aliphatischen Teils, die substituiert ist durch ein Heteroatom oder eine Gruppe des Anspruchs 1.

18. Positiv arbeitendes strahlungsempfindliches Gemisch nach Anspruch 17, dadurch gekennzeichnet, daß der cycloaliphatische Teil direkt benachbart ist zu einem Stickstoffatom, insbesondere der Gruppen

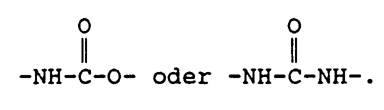

19. Positiv arbeitendes strahlungsempfindliches Gemisch nach Anspruch 17, dadurch gekennzeichnet, daß der cycloaliphatische Teil über eine Ethylengruppe mit dem Sauerstoffatom eines 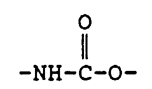 Restes verknüpft ist.

20. Positiv arbeitendes strahlungsempfindliches Gemisch nach Anspruch 12, dadurch gekennzeichnet, daß X ein araliphatischer Rest ist, wobei der aromatische Teil insbesondere einen Phenyl- bzw. Phenylenrest darstellt, der über ein Heteroatom mit dem aliphatischen Teil dieses Restes verknüpft ist.

21. Positiv arbeitendes strahlungsempfindliches Gemisch nach einem oder mehreren der Ansprüche 1 bis 20, dadurch gekennzeichnet, daß m eine ganze Zahl von 3 bis 8 und n eine ganze Zahl von 1 bis 3 ist.

22. Positiv arbeitendes strahlungsempfindliches Gemisch nach Anspruch 21, dadurch gekennzeichnet, daß m eine ganze Zahl von 3 bis 6 und n = 1 oder 2 ist.

23. Positiv arbeitendes strahlungsempfindliches Gemisch nach einem oder mehreren der Ansprüche 1 bis 22, dadurch gekennzeichnet, daß ein Gemisch aus mehreren, insbesondere zwei α-Diazo-β-ketoester-Sulfonsäureestern der allgemeinen Formel I im strahlungsempfindlichen Gemisch enthalten sind.

24. Positiv arbeitendes strahlungsempfindliches Gemisch nach einem oder mehreren der Ansprüche 1 bis 23, dadurch gekennzeichnet, daß die Konzentration der photoaktiven Komponenten im strahlungsempfindlichen Gemisch 4 bis 40 Gew.-%, insbesondere 6 bis 35 Gew.-%, beträgt.

25. Positiv arbeitendes strahlungsempfindliches Gemisch nach einem oder mehreren der Ansprüche 1 bis 24, dadurch gekennzeichnet, daß das Bindemittel im Wellenlängenbereich von 190 bis 300 nm eine geringe Eigenabsorption aufweist.

26. Positiv arbeitendes strahlungsempfindliches Gemisch nach einem oder mehreren der Ansprüche 1 bis 25, dadurch gekennzeichnet, daß das Bindemittel bis zu 30 Gew.-%, insbesondere bis zu 20 Gew.-%, ein Novolak-Kondensationsharz enthält.

27. Positiv arbeitendes strahlungsempfindliches Gemisch nach einem oder mehreren der Ansprüche 1 bis 26, dadurch gekennzeichnet, daß das Bindemittel phenolische Hydroxylgruppen enthält.

28. Positiv arbeitendes strahlungsempfindliches Gemisch nach einem oder mehreren der Ansprüche 1 bis 27, dadurch gekennzeichnet, daß das Bindemittel in einer Konzentration von 60 bis 96 Gew.-%, insbesondere 65 bis 94 Gew.-%, im strahlungsempfindlichen Gemisch enthalten ist.

29. Positiv arbeitendes Aufzeichnungsmaterial enthaltend einen Träger und ein darauf aufgetragenes positiv arbeitendes Gemisch, dadurch gekennzeichnet, daß das positiv arbeitende Gemisch einem Gemisch nach einem oder mehreren der Ansprüche 1 bis 28 entspricht.

30. Verfahren zur Herstellung eines positiv arbeitenden Aufzeichnungsmaterials nach Anspruch 29, dadurch gekennzeichnet, daß der ggf. mit einem Haftvermittler vorbehandelte Träger durch Aufsprühen, Walzen, Rakeln, Gießen, durch Fließbeschichten, Schleuderbeschichten und Tauchbeschichten oder mittels Breitschlitzdüsen mit dem strahlungsempfindlichen Gemisch beschichtet wird und das Lösemittel durch Verdampfen entfernt wird, so daß eine Schichtstärke von 0,1 bis 100 µm, insbesondere von 0,3 bis 10 µm, entsteht.

31. Verfahren nach Anspruch 30, dadurch gekennzeichnet, daß das Aufzeichnungsmaterial mit Licht einer Wellenlänge von 190 bis 300 nm bildmäßig belichtet wird und das entstehende Bild mittels einer wäßrigen Entwicklungslösung freigelegt wird.

32. Verfahren nach den Ansprüchen 30 oder 31, dadurch gekennzeichnet, daß die entstandene Struktur durch Erhitzen und/oder durch ganzflächige Belichtung nachgehärtet wird.

33. Verfahren nach Anspruch 30, dadurch gekennzeichnet, daß das strahlungsempfindliche Gemisch auf einen Zwischenträger aufgetragen wird, und von dem erst auf den endgültigen Träger auflaminiert wird.

## Claims

1. A positive-working radiation-sensitive mixture essentially containing a photoactive component and a water-insoluble binder which is soluble, or at least swellable, in aqueous alkaline solution, wherein a compound is used, as photoactive component, which contains α-diazo-β-keto ester units and sulfonic acid ester units and has the formula I 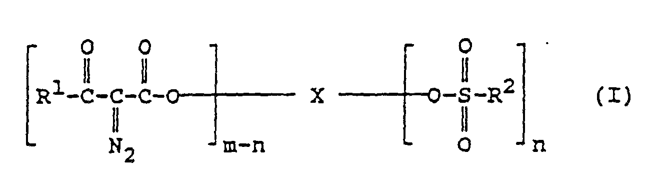 in which
R¹ is an aliphatic, cycloaliphatic, araliphatic or aromatic radical having 4 to 20 carbon atoms, it being possible for individual CH₂ groups to be replaced by oxygen or sulfur atoms or by -NR³- or NH groups and/or to contain keto groups,
R² is an aliphatic radical having 1 to 8 carbon atoms where CH₂ groups may be replaced by oxygen atoms or NH-groups and/or keto groups may be present, or any one of the radicals indicated for R¹,
X is an aliphatic, cycloaliphatic, carbocyclic, heterocyclic or araliphatic radical having 2 to 22 carbon atoms, it being possible for individual CH₂ groups to be replaced by oxygen or sulfur atoms or by the groups -NR³-, -C(O)-O-, -C(O)-NR³-, 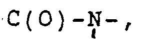 -NR³-C(O)-NR⁴-, -O-C(O)-NR³-, 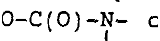 or -O-C(O)-O-, or for CH groups to be replaced by 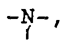 in which
R³ and R⁴, independently or one another, are hydrogen or an aliphatic, carbocyclic or araliphatic radical,
m is an integer from 3 to 8 and
n is an integer from 1 to 3.

2. A positive-working radiation-sensitive mixture as claimed in claim 1, wherein R³ and R⁴ are hydrogen, (C₁-C₃)alkyl, (C₆-C₁₂)aryl or (C₆-C₁₁)aralkyl, in particular (C₁-C₃)alkyl or hydrogen, it being possible for these, in particular aryl or aralkyl, to be substituted on the ring by (C₁-C₃)alkyl, (C₁-C₃)alkoxy, halogen, in particular chlorine or bromine, or amino.

3. A positive-working radiation-sensitive mixture as claimed in claim 1 or 2, wherein R¹, R² and/or X are substituted by (C₁-C₃)alkyl, (C₁-C₃)alkoxy, halogen, amino or nitrilo, in particular by (C₁-C₃)alkyl or (C₁-C₃)alkoxy.

4. A positive-working radiation-sensitive mixture as claimed in one or more of claims 1 to 3, wherein, if R¹ and/or R² are aliphatic radicals and if these are substituted, they contain in particular from 4 to 10 chain members.

5. A positive-working radiation-sensitive mixture as claimed in claim 4, wherein CH₂ groups have been replaced, in particular by oxygen atoms, -NH- groups or keto groups, and these radicals therefore contain ether, keto, ester, amido and/or imido groups.

6. A positive-working radiation-sensitive mixture as claimed in one or more of claims 1 to 3, wherein, if R¹ is an aliphatic radical and if this is unsubstituted, it contains up to 20 chain members.

7. A positive-working radiation-sensitive mixture as claimed in one or more of claims 1 to 3, wherein R¹ and/or R² are cycloaliphatic radicals having 4, 5, 6 or 12, in particular 4, 5 or 6, particularly preferably 6, ring members, and are, in particular, unsubstituted.

8. A positive-working radiation-sensitive mixture as claimed in one or more of claims 1 to 3, wherein R¹ and/or R² are araliphatic radicals having 2 to 11, in particular 2 to 5, chain members in the aliphatic moiety of the radical.

9. A positive-working radiation-sensitive mixture as claimed in claim 8, wherein the aliphatic moiety of the radical R¹ and/or R² contains 1 or 2 chain members if this moiety has a pure carbon chain.

10. A positive-working radiation-sensitive mixture as claimed in claim 8, wherein the aliphatic moiety of the radical R¹ contains 3 to 5 chain members if CH₂ groups in this moiety have been replaced by heteroatoms.

11. A positive-working radiation-sensitive mixture as claimed in claim 8, wherein the radical R² contains 1 to 8 chain members if this moiety is aliphatic and unsubstituted.

12. A positive-working radiation-sensitive mixture as claimed in one or more of claims 1 to 11, wherein a maximum of 5, in particular a maximum of 3, CH₂ groups in the radical X have been replaced by heteroatoms or said groups.

13. A positive-working radiation-sensitive mixture as claimed in one or more of claims 1 to 11, wherein the radical X is aliphatic and unsubstituted and has a maximum of 6 carbon atoms.

14. A positive-working radiation-sensitive mixture as claimed in claim 13, containing a maximum of one C-C multiple bond.

15. A positive-working radiation-sensitive mixture as claimed in claim 12, wherein the heteroatoms replacing CH₂ groups are of one type.

16. A positive-working radiation-sensitive mixture as claimed in claim 12, wherein, if a CH group has been replaced by 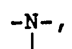 no further substitution is present in the radical X.

17. A positive-working radiation-sensitive mixture as claimed in claim 12, wherein X is a cycloaliphatic radical in which the cycloaliphatic moiety is unsubstituted and is adjacent to a CH₂ group of the aliphatic moiety which is substituted by a heteroatom or a group of claim 1.

18. A positive-working radiation-sensitive mixture as claimed in claim 17, wherein the cycloaliphatic moiety is directly adjacent to a nitrogen atom, in particular of the group

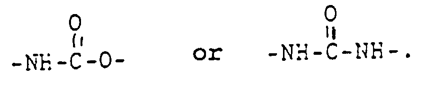

19. A positive-working radiation-sensitive mixture as claimed in claim 17, wherein the cycloaliphatic moiety is linked to the oxygen atom of a 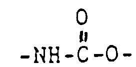 radical via an ethylene group.

20. A positive-working radiation-sensitive mixture as claimed in claim 12, wherein X is an araliphatic radical in which the aromatic moiety is, in particular, a phenyl or phenylene radical which is linked to the aliphatic moiety of this radical via a heteroatom.

21. A positive-working radiation-sensitive mixture as claimed in one or more of claims 1 to 20, wherein n is an integer from 3 to 8, and n is an integer from 1 to 3.

22. A positive-working radiation-sensitive mixture as claimed in claim 21, wherein m is an integer from 3 to 6, and n is 1 or 2.

23. A positive-working radiation-sensitive mixture as claimed in one or more of claims 1 to 22, wherein a mixture of a plurality of, in particular two, α-diazo-β-keto ester/sulfonic acid esters of the formula I is contained in the radiation-sensitive mixture.

24. A positive-working radiation-sensitive mixture as claimed in one or more of claims 1 to 23, wherein the concentration of the photoactive components in the radiation-sensitive mixture is 4 to 40% by weight, in particular 6 to 35% by weight.

25. A positive-working radiation-sensitive mixture as claimed in one or more of claims 1 to 24, wherein the binder has a low inherent absorption in the wavelength range from 190 to 300 nm.

26. A positive-working radiation-sensitive mixture as claimed in one or more of claims 1 to 25, wherein the binder contains up to 30% by weight, in particular up to 20% by weight, of a novolak condensation resin.

27. A positive-working radiation-sensitive mixture as claimed in one or more of claims 1 to 26, wherein the binder contains phenolic hydroxyl groups.

28. A positive-working radiation-sensitive mixture as claimed in one or more of claims 1 to 27, wherein the binder is contained in a concentration of 60 to 96% by weight, in particular 65 to 94% by weight, in the radiation-sensitive mixture.

29. A positive-working recording material comprising a support and a positive-working mixture applied thereto, wherein the positive-working mixture is a mixture as claimed in one or more of claims 1 to 28.

30. A process for producing a positive-working recording material as claimed in claim 29, comprising coating the Support, optionally pretreated with an adhesion promoter, with the radiation-sensitive mixture by spraying-on, rolling, knife-application, casting, by flow coating, spin coating and immersion coating or by means of slot dies and removing the solvent by evaporation, so that a coating thickness of 0.1 to 100 µm, in particular of 0.3 to 10 µm, is produced.

31. The process as claimed in claim 30, wherein the recording material is exposed imagewise to light having a wavelength of 190 to 300 nm and the image produced is laid bare by means of an aqueous developing solution.

32. The process as claimed in claim 30 or 31, wherein the structure produced is postcured by heating and/or by exposure over the entire area.

33. The process as claimed in claim 30, wherein the radiation-sensitive mixture is applied to an intermediate support and is laminated from the latter onto the final support.

## Revendications

1. Composition sensible aux radiations, travaillant en positif, contenant essentiellement un composant photo-actif et un liant insoluble dans l'eau, soluble ou au moins susceptible de gonfler dans une solution aqueuse-alcaline, caractérisée en ce que, en tant que composant photoactif, on utilise un composé à groupements α-diazo-β-cétoester et ester sulfonique, de formule générale I 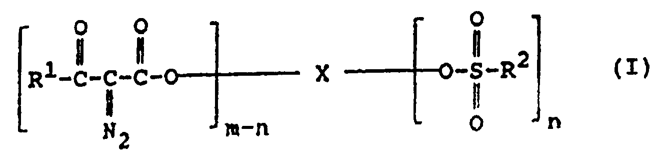 dans laquelle
R¹ représente un radical aliphatique, cycloaliphatique, araliphatique ou aromatique ayant de 4 à 20 atomes de carbone, des groupes CH₂ individuels pouvant être remplacés par des atomes d'oxygène ou de soufre ou par des groupes -NR³- ou NH, et/ou pouvant comprendre des groupes céto,
R² représente un radical aliphatique ayant de 1 à 8 atomes de carbone, dans lequel des groupes CH₂ peuvent être remplacés par des atomes d'oxygène ou des groupes NH, et/ou des groupes céto peuvent être présents, ou l'un des radicaux indiqués pour R¹,
X représente un radical aliphatique, cycloaliphatique, carbocyclique, hétérocyclique ou araliphatique ayant de 2 à 22 atomes de carbone, des groupes CH₂ individuels pouvant être remplacés par des atomes d'oxygène ou de soufre ou par les groupes -NR³-, -C(O)-O-, -C(O)-NR³-, 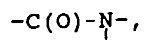 -NR³-C(O)-NR⁴-, -O-C(O)-NR³-, 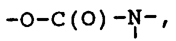 -O-C(O)-O-, ou des groupes CH pouvant être remplacés par 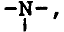 où
R³ et R⁴ représentent, indépendamment l'un de l'autre, un atome d'hydrogène ou un radical aliphatique, carbocyclique ou araliphatique,
m représente un nombre entier allant de 3 à 8, et
n représente un nombre entier allant de 1 à 3.

2. Composition sensible aux radiations, travaillant en positif, selon la revendication 1, caractérisée en ce que R³ et R⁴ représentent un atome d'hydrogène ou un groupe alkyle en C₁-C₃, aryle en C₆-C₁₂ ou aralkyle en C₆-C₁₁, en particulier un groupe alkyle en C₁-C₃ ou un atome d'hydrogène, ces groupes, en particulier les groupes aryle ou aralkyle, pouvant être substitués sur le noyau par des atomes d'halogène, en particulier de chlore ou de brome, ou par des groupes alkyle en C₁-C₃, alcoxy en C₁-C₃ ou amino.

3. Composition sensible aux radiations, travaillant en positif, selon la revendication 1 ou 2, caractérisée en ce que R¹, R² et/ou X sont substitués par des atomes d'halogène ou par des groupes alkyle en C₁-C₃, alcoxy en C₁-C₃, amino ou nitrilo, en particulier par des groupes alkyle en C₁-C₃ ou alcoxy en C₁-C₃.

4. Composition sensible aux radiations, travaillant en positif, selon une ou plusieurs des revendication 1 à 3, caractérisée en ce que, lorsque R¹ et R² représentent un radical aliphatique et celui-ci est substitué, il comporte en particulier 4 à 10 chaînons.

5. Composition sensible aux radiations, travaillant en positif, selon la revendication 4, caractérisée en ce que des groupes CH₂ sont remplacés en particulier par des atomes d'oxygène, des groupes -NH- ou des groupes céto, et ces radicaux par conséquent contiennent des groupes éther, céto, ester, amido et/ou imido.

6. Composition sensible aux radiations, travaillant en positif, selon une ou plusieurs des revendication 1 à 3, caractérisée en ce que, lorsque R¹ représente un radical aliphatique et celui-ci est non substitué, il comporte jusqu'à 20 chaînons.

7. Composition sensible aux radiations, travaillant en positif, selon une ou plusieurs des revendications 1 à 3, caractérisée en ce que R¹ et/ou R² représente(nt) un radical cycloaliphatique à 4, 5, 6 ou 12, en particulier 4, 5 ou 6 chaînons, de façon particulièrement préférée 6 chaînons de cycle, et qui en particulier n'est pas substitué.

8. Composition sensible aux radiations, travaillant en positif, selon une ou plusieurs des revendications 1 à 3, caractérisée en ce que R¹ et/ou R² est un radical araliphatique ayant de 2 à 11, en particulier de 2 à 5 chaînons dans le fragment aliphatique du radical.

9. Composition sensible aux radiations, travaillant en positif, selon la revendication 8, caractérisée en ce que le fragment aliphatique du radical R¹ et/ou du radical R² contient 1 ou 2 chaînons, dans la mesure où ce fragment comporte une chaîne purement carbonée.

10. Composition sensible aux radiations, travaillant en positif, selon la revendication 8, caractérisée en ce que le fragment aliphatique du radical R¹ comporte 3 à 5 chaînons, dans la mesure où dans ce fragment des groupes CH₂ sont remplacés par des hétéroatomes.

11. Composition sensible aux radiations, travaillant en positif, selon la revendication 8, caractérisée en ce que R² comporte 1 à 8 chaînons, dans la mesure où ce fragment est aliphatique et non substitué.

12. Composition sensible aux radiations, travaillant en positif, selon une ou plusieurs des revendications 1 à 11, caractérisée en ce que, dans le radical X, au maximum 5, en particulier au maximum 3 groupes CH₂ sont remplacés par les hétéroatomes ou les groupes cités.

13. Composition sensible aux radiations, travaillant en positif, selon une ou plusieurs des revendications 1 à 11, caractérisée en ce que le radical X est aliphatique et non substitué et comporte au maximum 6 atomes de carbone.

14. Composition sensible aux radiations, travaillant en positif, selon la revendication 13, caractérisée en ce qu'elle comporte au maximum une liaison multiple C-C.

15. Composition sensible aux radiations, travaillant en positif, selon la revendication 12, caractérisée en ce que les hétéroatomes remplaçant des groupes CH₂ sont d'un seul type.

16. Composition sensible aux radiations, travaillant en positif, selon la revendication 12, caractérisée en ce que, lorsqu'un groupe CH est remplacé par 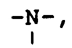 il n'y a aucune autre substitution sur le radical X.

17. Composition sensible aux radiations, travaillant en positif, selon la revendication 12, caractérisée en ce que X est un radical cycloaliphatique dans lequel le fragment cycloaliphatique n'est pas substitué et est voisin d'un groupe CH₂ du fragment aliphatique qui est substitué par un hétéroatome ou par un groupe de la revendication 1.

18. Composition sensible aux radiations, travaillant en positif, selon la revendication 17, caractérisée en ce que le fragment cycloaliphatique est immédiatement voisin d'un atome d'azote, en particulier des groupes 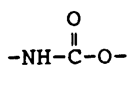 ou

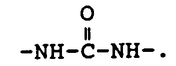

19. Composition sensible aux radiations, travaillant en positif, selon la revendication 17, caractérisée en ce que le fragment cycloaliphatique est lié, par l'intermédiaire d'un groupe éthylène, à l'atome d'oxygène d'un radical

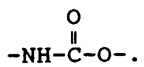

20. Composition sensible aux radiations, travaillant en positif, selon la revendication 12, caractérisée en ce que X est un radical araliphatique, le fragment aromatique représentant en particulier un radical phényle ou phénylène, qui est lié, par l'intermédiaire d'un hétéroatome, au fragment aliphatique de ce radical.

21. Composition sensible aux radiations, travaillant en positif, selon une ou plusieurs des revendications 1 à 20, caractérisée en ce que m est un nombre entier allant de 3 à 8, et n est un nombre entier allant de 1 à 3.

22. Composition sensible aux radiations, travaillant en positif, selon la revendication 21, caractérisée en ce que m est un nombre entier allant de 3 à 6, et n = 1 ou 2.

23. Composition sensible aux radiations, travaillant en positif, selon une ou plusieurs des revendications 1 à 22, caractérisée en ce qu'un mélange de plusieurs, en particulier de deux groupements α-diazo-β-cétoester et ester sulfonique de formule générale I est contenu dans la composition sensible aux radiations.

24. Composition sensible aux radiations, travaillant en positif, selon une ou plusieurs des revendications 1 à 23, caractérisée en ce que la concentration des composants photoactifs dans la composition sensible aux radiations va de 4 à 40 % en poids, en particulier de 6 à 35 % en poids.

25. Composition sensible aux radiations, travaillant en positif, selon une ou plusieurs des revendications 1 à 24, caractérisée en ce que le liant présente une faible autoabsorption dans la région de longueurs d'onde allant de 190 à 300 nm.

26. Composition sensible aux radiations, travaillant en positif, selon une ou plusieurs des revendications 1 à 25, caractérisée en ce que le liant contient jusqu'à 30 % en poids, en particulier jusqu'à 20 % en poids, d'une résine de condensation de type Novolaque.

27. Composition sensible aux radiations, travaillant en positif, selon une ou plusieurs des revendications 1 à 26, caractérisée en ce que le liant contient des groupes hydroxy phénoliques.

28. Composition sensible aux radiations, travaillant en positif, selon une ou plusieurs des revendications 1 à 27, caractérisée en ce que dans la composition sensible aux radiations le liant est contenu à une concentration de 60 à 96 % en poids, en particulier de 65 à 94 % en poids.

29. Matériau de reprographie travaillant en positif, contenant un support et une composition travaillant en positif appliquée sur celui-ci, caractérisé en ce que la composition travaillant en positif correspond à une composition selon une ou plusieurs des revendications 1 à 28.

30. Procédé pour la production d'un matériau de reprographie travaillant en positif, selon la revendication 29, caractérisé en ce que le support, éventuellement prétraité par un agent favorisant l'adhérence, est revêtu avec la composition photosensible, par pulvérisation, application au rouleau, enduction à la racle, coulage, par enduction par ruissellement, enduction par projection centrifuge ou enduction par immersion ou au moyen de filières plates, et le solvant est éliminé par évaporation, de sorte qu'il en résulte une épaisseur de couche de 0,1 à 100 µm, en particulier de 0,3 à 10 µm.

31. Procédé selon la revendication 30, caractérisé en ce que le matériau de reprographie est insolé selon l'image avec de la lumière d'une longueur d'onde de 190 à 300 nm, et l'image résultante est dégagée à l'aide d'une solution aqueuse de développement.

32. Procédé selon la revendication 30 ou 31, caractérisé en ce que la structure obtenue est post-durcie par chauffage et/ou par insolation de toute la surface.

33. Procédé selon la revendication 30, caractérisé en ce que la composition sensible aux radiations est appliquée sur un support intermédiaire et, de celui-ci, seulement alors appliquée par laminage sur le support final.
